# EUROPEAN PATENT SPECIFICATION

(11) **EP 0 367 293 B1**
(45) Date of publication and mention of the grant of the patent: **11.03.1998**
(21) Application number: 89120501.5
(22) Date of filing: 06.11.1989
(51) Int. Cl.: H01L 29/732, H01L 21/331, H01L 21/8228, H01L 27/082

(54) **Methods of fabricating semiconductor devices having a bipolar transistor**
Verfahren zur Herstellung von Halbleiteranordnungen mit einem Bipolartransistor
Méthodes de fabrication de dispositifs semi-conducteurs comprenant un transistor bipolaire

(30) Priority: 04.11.1988 JP 278700/88
(43) Date of publication of application: 09.05.1990
(73) Proprietor: MATSUSHITA ELECTRIC INDUSTRIAL CO., LTD., Kadoma-shi, Osaka-fu, 571 (JP)
(72) Inventor: Kanda, Akihiro, Neyagawa-shi Osaka (JP); Fujita, Yoshiro, Yao-shi Osaka (JP); Hirai, Takehiro, Kyoto-shi Kyoto (JP); Tanaka, Mitsuo, Moriguchi-shi Osaka (JP); Esaki, Hideya, Toyonaka-shi Osaka (JP)
(74) Representative: Tiedtke, Harro, Dipl.-Ing.

(56) References cited:
- EP-A- 0 033 495
- EP-A- 0 135 408
- EP-A- 0 139 165
- EP-A- 0 170 250
- EP-A- 0 193 934
- EP-A- 0 337 720

## Description

This invention relates to a method of manufacturing a high speed, high density semiconductor device and, more particularly, to a method of manufacturing a bipolar semiconductor device.

EP-A-0 193 934 discloses a method of manufacturing a semiconductor integrated circuit device, wherein a base and an emitter are formed by self-alignment. Thus, the emitter-base capacitance, the base-collector capacitance, the base resistance etc. are reduced, increasing thereby the operation speed of the transistor. However, since a collector diffusion region is spaced apart from a base diffusion region by an insulator region, the collector-substrate capacitance, the collector resistance and device area are increased.

EP-A-0 170 250 describes another method of manufacturing a vertical bipolar transistor. In this transistor, too, an insulation region is arranged between a base diffusion region and a collector diffusion region.

EP-A-0 337 720 which is comprised in the state of the art as defined in Article 54(3)EPC discloses a method of fabricating a high-performance bipolar transistor using a self-alignment process for the emitter, base and collector regions.

EP-A-0 139 165 relates to a vertical bipolar transistor without remote collector and describes metal electrodes for the emitter, collector and base contacts, which are not capable of diffusing impurities into the substrate to form an emitter diffusion layer, a collector-contact diffusion layer and a base-contact diffusion layer.

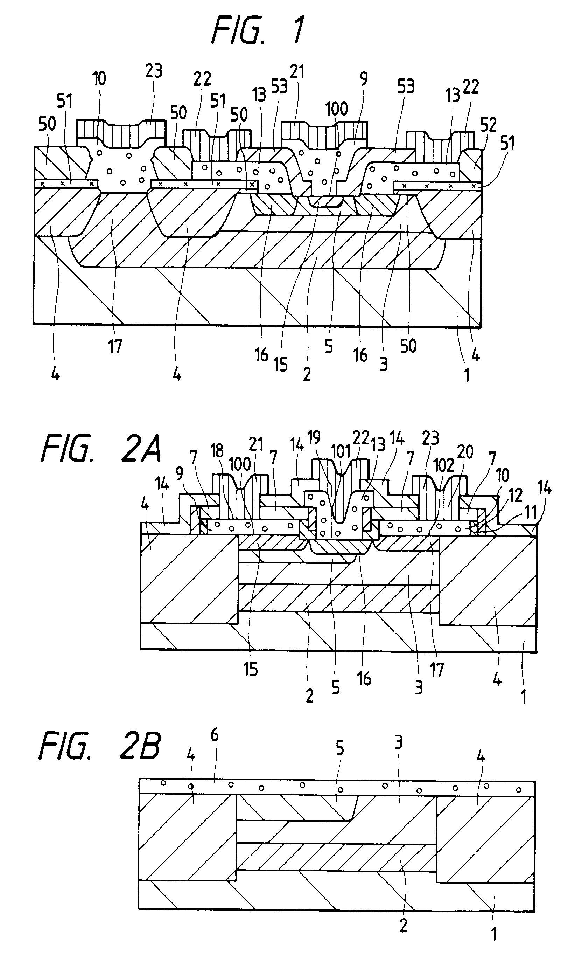

A method of manufacturing a semiconductor device by forming the base and emitter by self-alignment for increasing the speed of operation and density is frequently used. Fig. 1 shows a transistor with the base and emitter formed by self-alignment (shown in, for instance, the 1983 National Meeting of the Semiconductor Material Department of the Institute of Electronics and Communication Engineers of Japan, p.247).

Referring to Fig. 1, designated at 1 is p-type (111) semiconductor substrate, 2 n-type buried layer, 3 n-type epitaxial layer, 4 isolated region consisting of a SiO₂ film, 5 base diffusion layer, 9 emitter electrode consisting of a polycrystalline silicon film containing arsenic, 10 collector electrode consisting of a polycrystalline silicon film containing arsenic, 13 base electrode consisting of a polycrystalline silicon film containing boron, 15 emitter diffusion layer, 16 base contact diffusion layer, 21 to 23 electrode leads of aluminum or the like, 50, 52 and 53 SiO₂ films, 51 Si₃N₄ film, 100 emitter contact.

The base and emitter are formed by self-alignment by forming base electrode 13, then forming a SiO₂ film by an anisotropic dry etching process and then dry etching it to leave SiO₂ film 53 on a side surface of base electrode 13 and form emitter contact 100. As is shown, by the prior art process finer emitter and base are formed by using a self-alignment technique, thus reducing the emitter-base capacitance, base-collector capacitance, base resistance, etc. and thus increasing the operation speed of the transistor. However, the collector region is not made so fine compared to the finer emitter and base, and the collector area, collector-substrate capacitance and collector resistance are not reduced to the disadvantage.

This invention has been intended in the light of the above, and its object is to a method of manufacturing a high speed, high density semiconductor device with emitter, base and collector contacts formed by self-alignment process and having reduced element area.

To attain the above object of the invention, there is provided a method of fabricating a semiconductor device according to any one of claims 1, 2, 8 and 11.

According to the invention, with the emitter, base and collector contacts formed as self-aligned contacts, it is possible to realize a high speed, high density semiconductor device, which can greatly reduce the element area, reduce emitter-base and base-collector capacitances and base resistance and further reduce the collector area, collector-substrate capacitance and collector resistance.
Fig. 1 is a fragmentary pictorial sectional view showing a semiconductor device with base and emitter formed by a self-alignment technique:
Figs. 2B to 2G, 3B to 3D, 4B to 4F, 5B to 5K and 6B to 6I are fragmentary pictorial sectional views showing manufacturing steps according to the invention; and

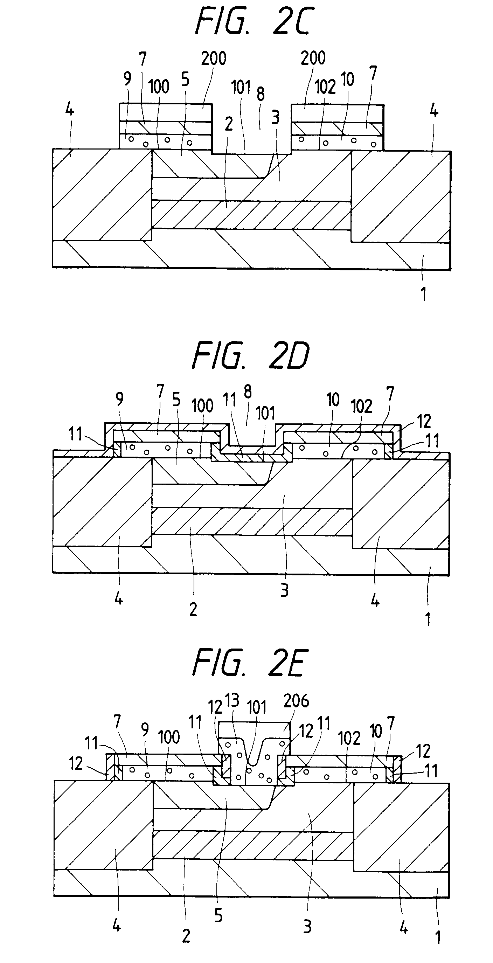

Figs. 2A, 2H, 3A, 4A, 5A, 5L, 6A, 6J and 6K are fragmentary pictorial sectional views showing embodiments of semiconductor devices fabricated according to the invention.

### (Embodiment 1)

Fig. 2A shows a completed bipolar semiconductor device manufactured according to Embodiment 1. Referring to the Figure, reference numeral 1 designates p-type (111) semiconductor substrate, 2 n-type buried layer, 3 n-type epitaxial layer, 4 isolating region consisting of a SiO₂ film, 5 base diffusion layer, 11, 12 and 14 SiO₂ films, 9 emitter electrode consisting of a polycrystalline silicon film containing an n-type impurity, e.g., arsenic or phosphorus, 10 collector electrode consisting of a polycrystalline silicon film containing an n-type impurity, e.g., arsenic or phosphorus, 13 base electrode consisting of a polycrystalline silicon film containing a p-type impurity, e.g., boron, 15 emitter diffusion layer, 16 base contact diffusion layer, 17 collector contact diffusion layer, 18 emitter contact window, 19 base contact window, 20 collector contact window, 21 to 23 electrode leads of aluminum or the like, 100 emitter contact, 101 base contact, and 102 collector contact.

Now, the method of manufacturing the bipolar semiconductor device shown in Fig. 2A will be described with reference to Figs. 2B to 2G. Arsenic is ion implanted under conditions of 60 keV and 1 x 10¹⁵/cm² with a resist as mask into p-type (111) semiconductor substrate 1 with a resistivity of 10 to 20 Ω · cm, for instance, to form n-type buried layer 2, and then n-type epitaxial layer 3 with a resistivity of 0.6 Ω · cm and a thickness of about 1 micron is formed. Then, isolating region 4 is formed using a BOX (Buried Oxide) isolation process, for instance. Then, silicon on an island surface surrounded by isolating region 4 is exposed, and boron is ion implanted with a resist as mask and under conditions of 20 keV and 1.5 x 10¹⁵/cm², thus forming base diffusion layer 5. In this case, it is possible to form a thin SiO₂ film on the island surface, then form base diffusion layer 5 by ion implantation through this thin SiO₂ film and then remove the thin SiO₂ film. Subsequently, the resist is removed, about 3,000·10⁻¹⁰ m (3,000-angstrom) polycrystalline silicon film 6 containing an n-type impurity, e.g., arsenic or phosphorus, is deposited by a reduced pressure CVD process, for instance (Fig. 2B). It is possible to deposit a non-doped polycrystalline silicon film, then ion implant arsenic under conditions 60 keV and 1 x 10¹³/cm² and introduce an n-type impurity into this polycrystalline silicon film.

Then, about 2500·10⁻¹⁰ m (2500-angstrom) SiO₂ film 7 is deposited by a CVD process, for instance. Then, SiO₂ film 7 and polycrystalline silicon film 6 in a region of base contact 101 are etched by anisotropic etching, for instance, with resist 200 as mask to form aperture 8 while simultaneously forming a polycrystalline silicon film pattern constituting emitter and collector electrodes 9 and 10 (Fig. 2C). In the above way, emitter, base and collector contacts 100 to 102 are formed as self-aligned contacts.

Resist 200 is then removed, and then about 500·10⁻¹⁰ m (500-angstrom) SiO₂ film 11 is formed by oxidization at 900°C for about 30 minutes, and then about 2000·10⁻¹⁰ m (2000-angstrom) SiO₂ film 12 is formed by the CVD process (Fig. 2D).

Then, SiO₂ films 11 and 12 are etched by anisotropic dry etching to leave then only on side surfaces of polycrystalline silicon films constituting emitter and collector electrodes 9 and 10. Then, about 3000·10⁻¹⁰ m (3000-angstrom) polycrystalline silicon film containing a p-type impurity, e.g., boron, is deposited by the reduced pressure CVD process, for instance, and it is etched with resist 206 as mask to form base electrode 13 (Fig. 2B). Alternatively, it is possible to deposite a non-doped polycrystalline silicon film and then introduce a p-type impurity into the polycrystalline silicon film, for instance by implanting boron under conditions of 30 keV and 1 x 10¹⁶/cm².

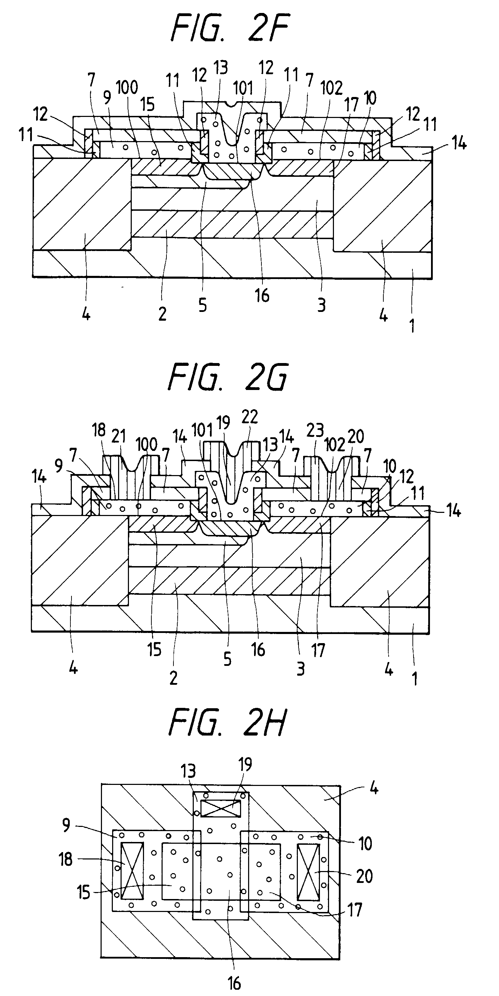

Resist 206 is then removed, and about 2000·10⁻¹⁰ m (2000-angstrom) SiO₂ film 14 formed by the CVD process, for instance. Then, n-type impurity is diffused from n-type polycrystalline silicon film for constituting emitter and collector electrodes 9 and 10, and p-type impurity from polycrystalline silicon film for constituting base electrode 13, through a thermal treatment at 950°C for about 40 minutes, thus forming emitter diffusion layer 15, base and collector contact diffusion layers 16 and 17. The diffusion at this time is performed such that the emitter-base and base-collector junctions are found under SiO₂ film 11 or 12 formed on side surface of polycrystalline silicon constituting emitter and collector electrodes 9 and 10 (Fig. 2F). When it is necessary to provide a high junction breakdown voltage, it is necessary to set the thickness of SiO₂ film 12 and thermal treatment conditions to optimum values lest emitter diffusion layer 15 and collector contact diffusion layer 17 should be contiguous to base contact diffusion layer 16. Further, while emitter diffusion layer 15, base and collector contact diffusion layers 16 and 17 are formed simultaneously by a thermal treatment under conditions 950°C and about 40 minutes, for performing diffusion of a p-type impurity having a high diffusion coefficient may be performed as the last step it is possible to perform a thermal treatment at 950°C for about 40 minutes prior to deposition of polycrystalline silicon film containing p-type impurity for base electrode 13, then form emitter diffusion layer 15 and collector contact diffusion layer 17, then form base electrode 13 and then form base contact diffusion layer 16 by a thermal treatment at 900°C for 30 minutes.

Finally, emitter, base and collector contact windows 18 to 20 are formed in SiO₂ films 7 and 14, and then electrode leads 21 to 23 of aluminum, for instance, are formed, thus completing the semiconductor device (Fig. 2G).

As has been shown, in this embodiment emitter and collector electrodes are simultaneously formed from a common doped polycrystalline silicon film, the base contact region is defined between the polycrystalline silicon films of the emitter and collector electrodes, and emitter and collector electrodes and base electrode are insulated by insulating film formed on the top and side surfaces of the polycrystalline silicon films, thus forming the base, emitter and collector contacts as self-aligned contacts. It is thus possible to realize a high speed, high density semiconductor device, which does not only permit reduction of the emitter-base and base-collector capacitances and base resistance but also has low collector-substrate capacitance and collector resistance.

Further, in the above embodiment contact windows 18 to 20 are formed on element region, it is also possible to form these windows on an isolating oxide film, and in this case the element area and junction capacitance can be further reduced (Fig. 2H).

### (Embodiment 2)

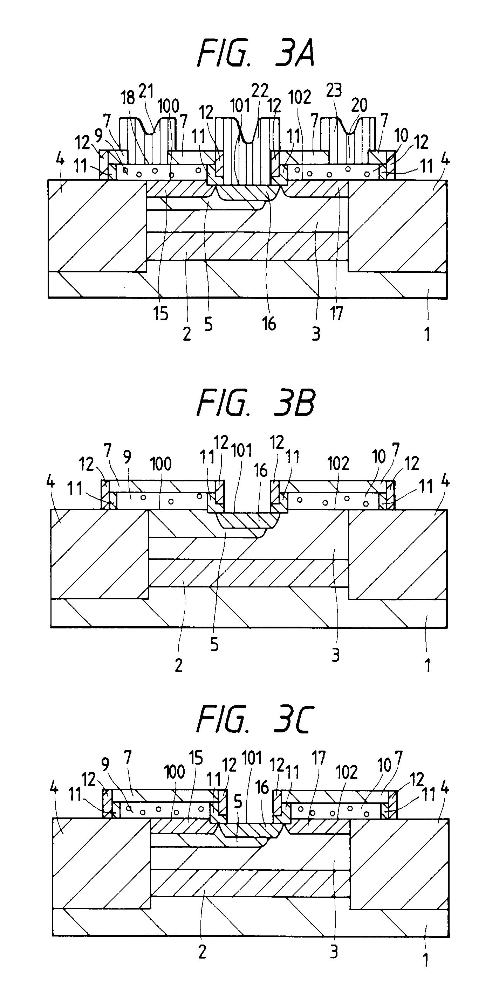

Fig. 3A shows a completed bipolar semiconductor device manufactured according to Embodiment 2. In Fig. 3A, reference numerals all correspond to like reference numerals in Fig. 2A.

The method of manufacturing the bipolar semiconductor device shown in Fig. 3A will now be described with reference to Figs. 2B to 2D and 3B to 3D. This method is the same as the method of Embodiment 1 in steps of Figs. 2B to 2D. Subsequent to the step of Fig. 2D, SiO₂ films 11 and 12 are etched by anisotropic dry etching to leave them only on side surfaces of polycrystalline silicon film for emitter and collector electrodes 9 and 10. Then, BF2, for instance, is ion implanted under conditions of 30 keV and 1 x 10¹⁵/cm² in a region constituting base contact 101 with SiO₂ film 7 as mask thus forming base contact diffusion layer 16 (Fig. 3B).

Then, n-type impurity is diffused from n-type polycrystalline silicon film constituting emitter and collector electrodes 9 and 10 by a thermal treatment at 950 °C for about 40 minutes, thus forming emitter diffusion layer 15 and collector diffusion layer 17. At this time, diffusion is performed such that the emitter-base and base-collector junctions are found under SiO₂ film 11 or 12 formed on side surfaces of polycrystalline silicon constituting emitter and collector electrodes 9 and 10 (Fig. 3C). When it is necessary to increase the junction breakdown voltage, it is necessary to set the thickness of SiO₂ film 12 and thermal treatment conditions to optimum values lest emitter diffusion layer 15 and collector contact diffusion layer 17 should be continuous to base contact diffusion region 16. Further, for performing the diffusion of a p-type having a high diffusion coefficient it is possible to perform a thermal treatment, for instance under conditions of 950°C and 40 minutes, prior to ion implantation of BF2 in region constituting base contact 101 and, after formation of emitter diffusion layer 15 and collector contact diffusion layer 17, ion implant BF₂ into a region constituting base contact 101, followed by a thermal treatment at 900°C for about 30 minutes to form base contact diffusion layer 16.

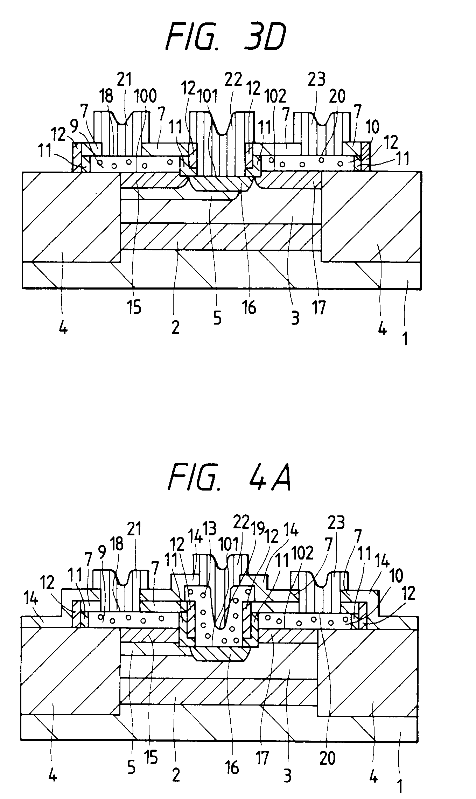

Finally, emitter and collector contact windows 18 and 20 are formed in SiO₂ film 7, and then electrode leads 21 to 23 of aluminum or the like are formed to complete the semiconductor device (Fig. 3D).

As has been shown, in this embodiment like Embodiment 1 base, emitter and collector contacts are formed as self-aligned contacts. It is thus possible to greatly reduce the element area and realize a high speed, high density semiconductor device. Further, the base contact is directly connected to the lead electrode without forming any polycrystalline silicon film constituting base electrode. Thus, the number of steps involved is reduced to permit cost reduction.

### (Embodiment 3)

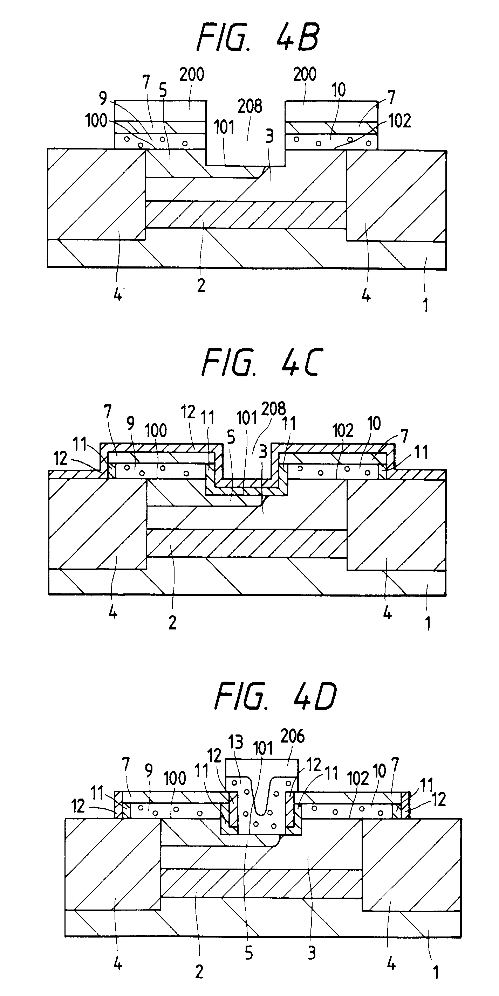

Fig. 4A shows a completed bipolar semiconductor device manufactured according to Embodiment 3. In Fig. 3A, reference numerals all correspond to like reference numerals in Fig. 2A.

The method of manufacturing a bipolar semiconductor device shown in Fig. 4A will now be described with reference to Figs. 4B to 4F. This method is the same as the method of Embodiment 1 up to step of Fig. 2B. Subsequent to the step of Fig. 2B, about 2500·10⁻¹⁰ m (2500-angstrom) SiO₂ film 7 is deposited by the CVD process, for instance. Then, SiO₂ film 7, polycrystalline silicon film 6 and n-type epitaxial layer 3 in a region constituting base contact 101 are etched by anisotropic etching, for instance, with resist 200 at mask, thus forming groove 208, thus simultaneously forming polycrystalline silicon patterns constituting emitter and collector electrodes 9 and 10 (Fig. 4B). Thus, emitter base and collector contacts 100 to 102 are formed as self-aligned contacts. At this time, n-type epitaxial layer 3 is etched to form groove 208 such that the bottom thereof is above the bottom surface of base diffusion layer 5.

Then, resist 200 is removed, and then about 500·10⁻¹⁰ m (500-angstrom) SiO₂ film 11 is formed by oxidization at 900°C for about 30 minutes. Then, about 2000·10⁻¹⁰ m (2000-angstrom) SiO₂ film 12 is formed by the CVD process (Fig. 4C).

Then, SiO₂ films 11 and 12 are etched to leave them only on side surfaces of polycrystalline silicon films constituting emitter and collector electrodes 9 and 10 and side surfaces of groove 208. Then, an about 3000·10⁻¹⁰ m (3000-angstrom) polycrystalline silicon film containing a p-type impurity, e.g. boron, is deposited by reduced pressure CVD process, for instance, and then it is etched with resist 206 as mask to form base electrode 13 (Fig. 4D). Alternatively, it is possible to deposit a non-doped polycrystalline silicon film, then ion implant boron, for instance, as p-type impurity, in the polycrystalline silicon film under conditions 30 keV and 1 x 10¹⁵/cm²

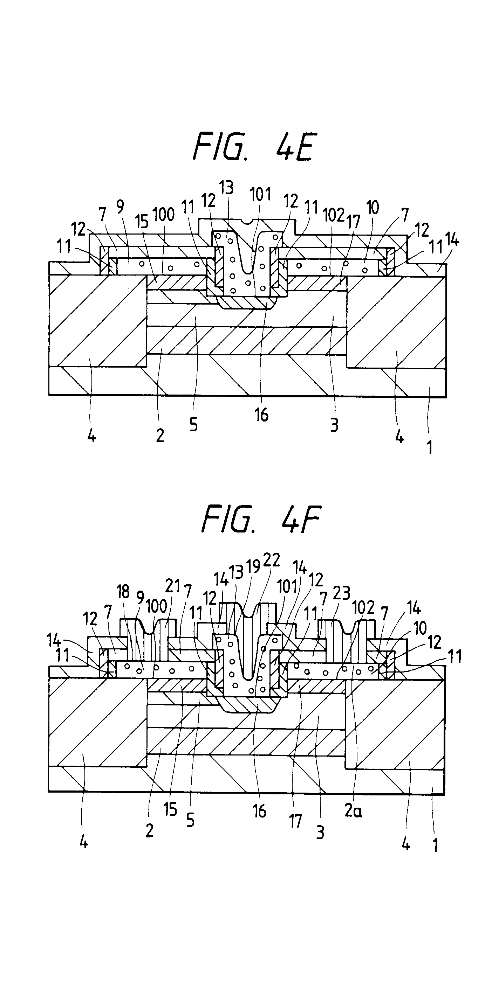

Resist 206 is then removed, then about 2000·10⁻¹⁰ m (2000-angstrom) SiO₂ film 14 is formed by the CVD process, for instance. Then, n-type impurity is diffused from n-type polycrystalline silicon film for emitter and collector electrodes 9 and 10, and p-type impurity from p-type polycrystalline silicon film for base electrode 13, by a thermal treatment at 950°C for about 40 minutes, thus forming emitter diffusion layer 15, base and collector contact diffusion layers 16 and 17. The diffusion at this time is performed such that the bottom surface of emitter diffusion layer 15 and collector contact diffusion layer 17 is shallower than the surface of base contact diffusion layer 16 so that emitter diffusion layer 15 and collector contact diffusion layer 17 are surrounded by SiO₂ film (Fig. 4E). By so doing, it is possible to reduce the emitter-base capacitance and increase the operation speed of the transistor. Further, the junction breakdown voltage can be increased for emitter diffusion layer 15 and collector contact diffusion layer 17 are not contiguous to base contact diffusion layer 16. Further, while emitter diffusion layer 15, base and collector contact diffusion layer 16 and 17 are formed simultaneously by a heat treatment at 950°C for 40 minutes, for performing the diffusion of a p-type impurity having a high diffusion coefficient it is possible to perform a thermal treatment at 950°C for 40 minutes prior to the deposition of polycrystalline silicon film containing p-type impurity constituting base electrode 13 and, after formation of emitter diffusion layer 15 and contact diffusion layer 17, form base electrode 13, followed by a thermal treatment at 900°C for about 30 minutes to form base contact diffusion layer 16.

Finally, emitter, base and collector contact windows 18 to 20 are formed in SiO₂ films 7 and 14, and electrode leads 21 to 23 of aluminum or the like are formed to complete the semiconductor device (Fig. 4F).

Further, in the above embodiment like Embodiment 1 contact windows 18 to 20 may be formed on an isolating oxide film, thus permitting further reduction of the element area and junction capacitance.

### (Embodiment 4)

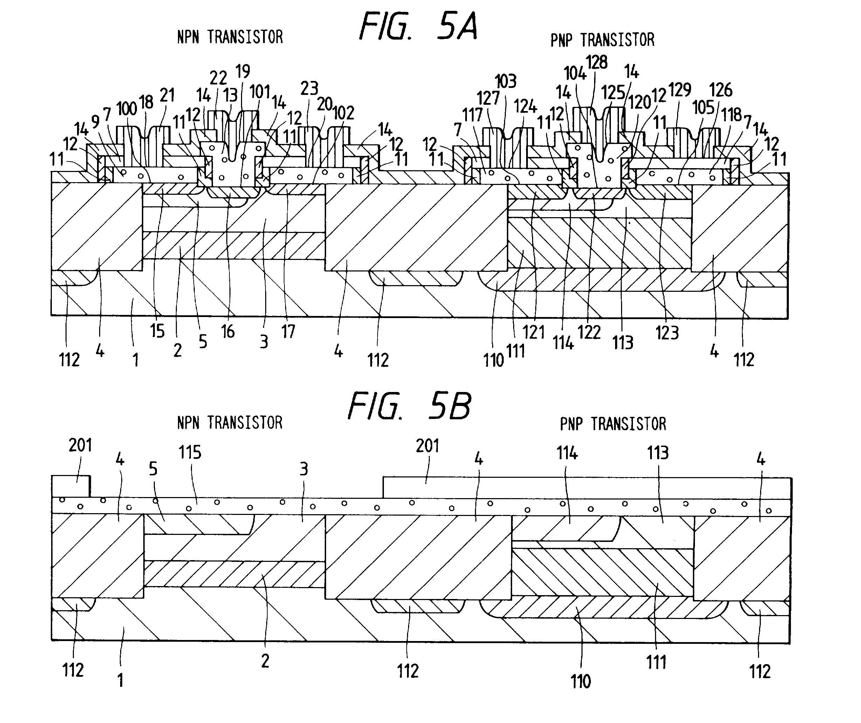

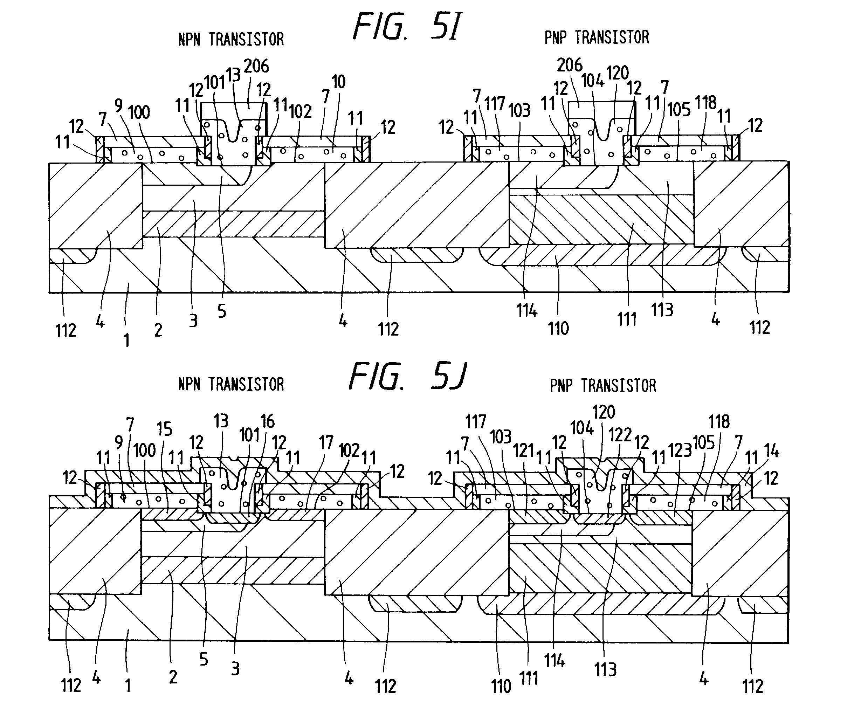

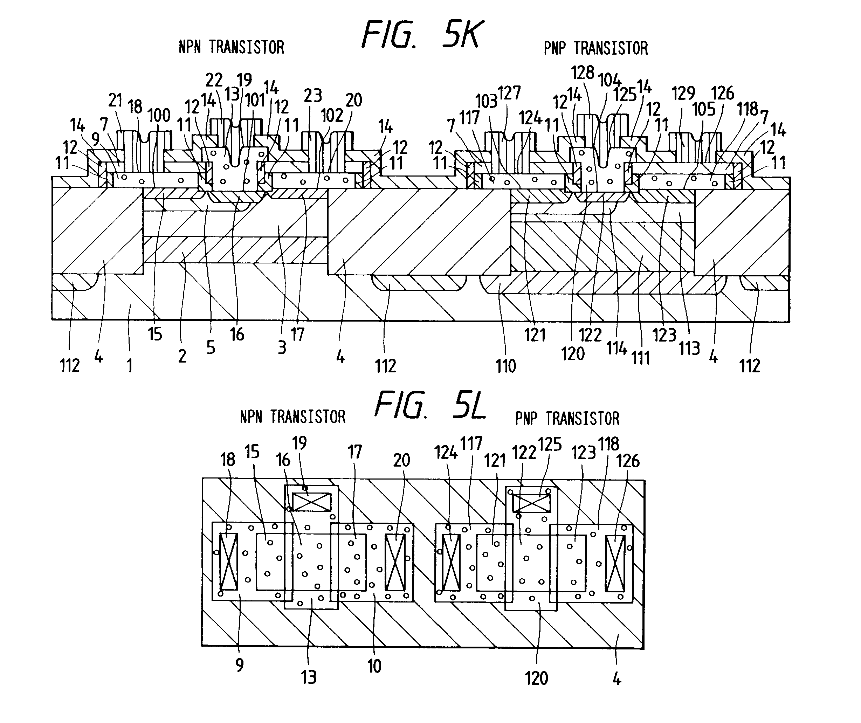

Fig. 5A shows a completed bipolar semiconductor device manufactured according to Embodiment 4 with PNP and NPN transistors formed on the same substrate. Concerning the PNP transistor shown in Fig. 5A, reference numeral 110 designates n-type buried layer, 111 p-type buried layer, 112 p-type channel stopper, 113 p-type well region, 114 base diffusion layer 117 emitter electrode consisting of a polycrystalline silicon film containing a p-type impurity e.g., boron, 118 a collector electrode consisting of a polycrystalline silicon film containing a p-type impurity, e.g., boron, 120 base electrode consisting of a polycrystalline silicon film containing an n-type impurity, e.g., arsenic or phosphorus, 121 emitter diffusion layer, 122 base contact diffusion layer, 123 collector contact diffusion layer, 124 emitter contact window, 125 base contact window, 126 collector contact window, 127 to 129 electrode leads of aluminum or the like, 103 emitter contact, 104 base contact, and 105 collector contact. Concerning the NPN transistor shown in Fig. 5A, reference numerals all correspond to those indicated in Fig. 2A.

Now, the method of manufacturing the bipolar semiconductor device shown in Fig. 5A will be described with reference to Figs. 5B to 5L. N-type buried layer 110 is formed by ion implanting phosphorus in a region of p-type (111) semiconductor substrate 1 with a resistivity of 10 to 20 Ω · cm, in which a PNP transistor is to be formed, with a resist as mask and under conditions of 80 keV and 1 x 10¹⁵/cm². Then, p-type buried layer 111 is formed by ion implantation of boron under conditions of 60 keV and 1 x 10¹⁵/cm². Then, n-type buried layer 2 is formed by ion implanting arsenic in a region, in which an NPN transistor is to be formed with a new resist as mask and under conditions of 60 keV and 1 x 10¹⁵/cm². Then, n-type epitaxial layer 3 with a resistivity of 1,0 Ω · cm and thickness of about 1,5 micrometres, and an isolating region 4 is formed using a BOX isolating process. At this time, p-channel stopper 112 is formed in advance under isolating region 4. then, silicon on an island region surface surrounded by isolating region 4 is exposed and p-type well region 113 for collector of the PNP transistor is formed by implanting boron, for instance, with a resist at mask and under conditions of 60 keV and 1,0 x 10¹⁵/cm².

Then, with a new resist as mask phosphorus is ion implanted under conditions of, for instance, 60 keV and 2,0 x 10¹⁵/cm² in a region, in which the PNP transistor is to be formed, thus forming base diffusion layer 114 of the PNP transistor. Then, with a new resist as mask boron is ion implanted under conditions of, for instance, 20 keV and 1,5 x 10¹⁵/cm² in an island region, in which the NPN transistor is formed, thus forming base diffusion layer 5 of the NPN transistor. Alternatively, it is possible to form a thin SiO₂ film on the island region surface, perform ion implantation through this thin SiO₂ film to form base diffusion layers 114 and 5 and then remove the thin SiO₂ film. Then, after removing the resist, about 3000·10⁻¹⁰ m (3000-angstrom) polycrystaline silicon film 115 is deposited by reduced pressure CVD process, for instance. Then, with resist 201 as mask arsenic is ion implanted under conditions of 60 keV and 1 x 10¹⁵/cm² in polycrystalline silicon film 115 on the island region, in which the NPN transistor is formed (Fig. 5B).

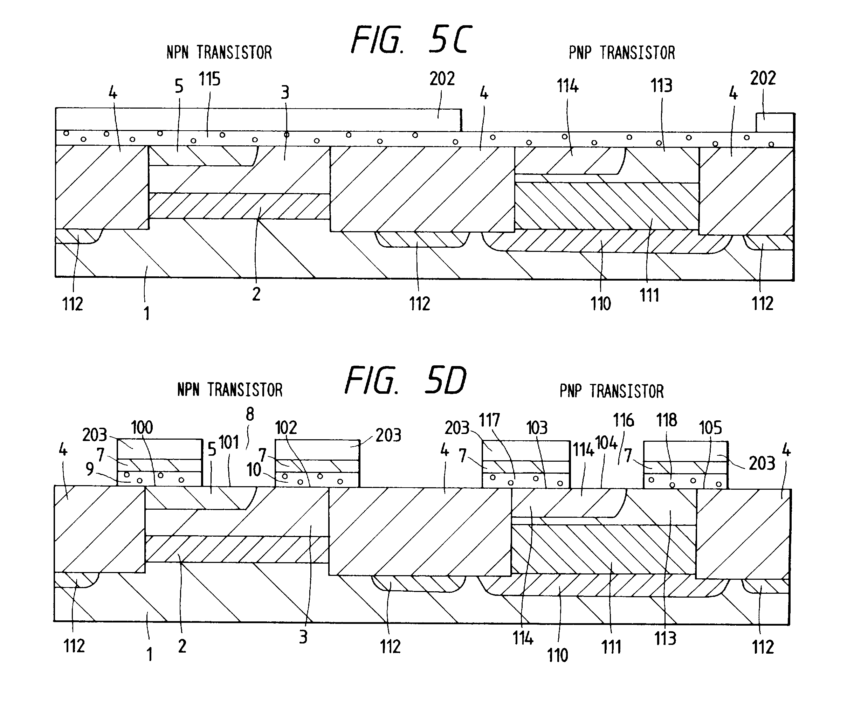

Then, after removing resist 201 boron is ion implanted under conditions of 20 keV and 1 x 10¹⁵/cm² in polycrystalline silicon film 115 on the island region, in which the PNP transistor is formed, with resist 202 as mask (Fig. 5C).

Then, about 2500·10⁻¹⁰ m (2500-angstrom) SiO₂ film 7 is deposited by CVD process, for instance. Then, with resist 203 as mask apertures 8 and 116 are formed in SiO₂ film 7 and polycrystalline silicon film 115 on region constituting base contact 101 of the NPN transistor and region of base contact 104 of the PNP transistor, while simultaneously forming polycrystalline silicon patterns of emitter and collector electrodes 9 and 10 of the NPN transistor and emitter and collector electrodes 117 and 118 of the PNP transistor (Fig. 5D). Thus, emitter, base and collector contacts 100 to 102 of the NPN transistor and emitter, base and collector contacts 103 to 105 of the PNP transistor are formed as self-aligned contacts.

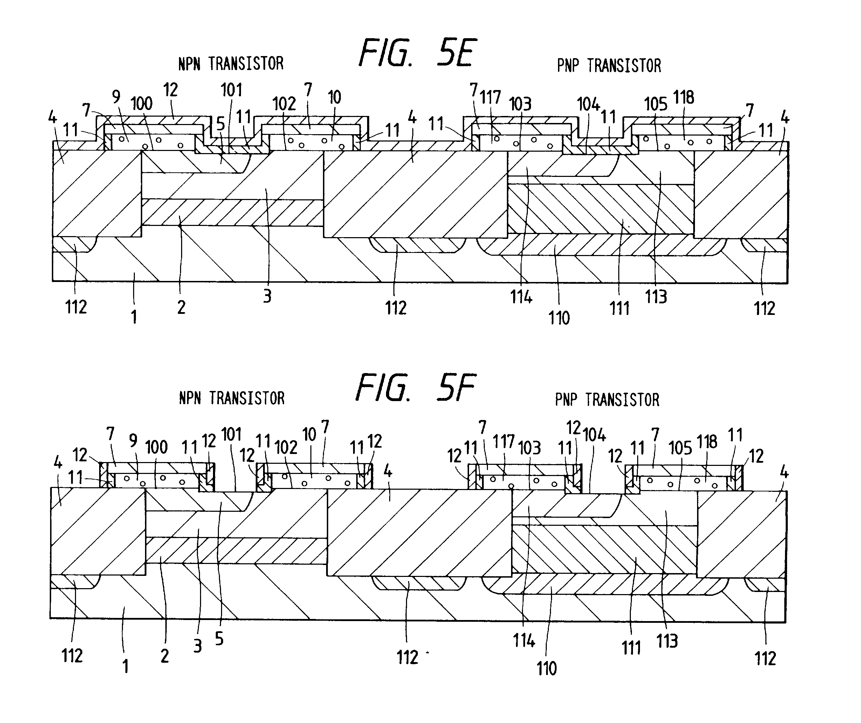

Resist 203 is then removed, then about 500·10⁻¹⁰ m (500-angstrom) SiO₂ film 11 is formed by oxidation at 900°C for 30 minutes, and then about 2000·10⁻¹⁰ m (2000-angstrom) SiO₂ film 12 is formed by the CVD process (Fig. 5E).

Then, SiO₂ films 11 and 12 are etched by anisotropic etching to leave them only on side surfaces of the polycrystalline silicon films constituting emitter electrodes 9 and 117 and collector electrodes 10 and 118 (fig. 5F).

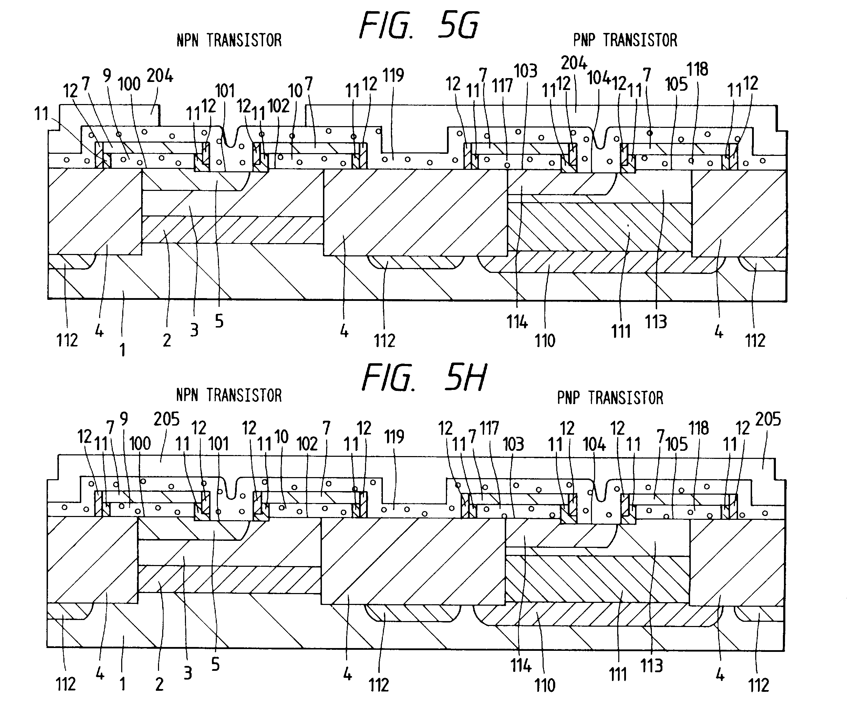

Then, about 3000·10⁻¹⁰ m (3000-angstrom) polycrystalline silicon film 119 is deposited on reduced pressure CVD process, for instance. Then, with resist 204 as mask boron is ion implanted under conditions of 20 keV and 1 x 10¹⁵/cm² in polycrystalline silicon film 119 on the island region, in which the NPN transistor is formed (Fig. 5G).

Resist 204 is then removed, and arsenic is ion implanted under conditions of, for instance, 30 keV and 1 x 10¹⁵/cm² within polycrystalline silicon film on the island region where the PNP transistor is formed with resist 205 as mask (Fig. 5H).

Resist 205 is then removed, and with resist 206 as mask polycrystalline silicon film 119 is dry etched to form base electrodes 13 and 120 of the respective NPN and PNP transistors (Fig. 5I).

Then, resist 206 is removed, and about 2000·10⁻¹⁰ m (2000-angstrom) SiO₂ film 14 is formed by CVD process, for instance. Then, arsenic is diffused from emitter and collector electrodes 9 and 10 of the NPN transistor and base electrode 120 of the PNP transistor by a thermal treatment at 950°C for 40 minutes, thus forming emitter diffusion layer 15 and collector contact diffusion layer 17 of the NPN transistor and base contact diffusion layer 122 of the PNP transistor. At the same time, boron is diffused base electrode 13 of the NPN transistor and emitter and collector electrodes 117 and 118 of the PNP transistor, thus forming base contact diffusion layer of the NPN transistor and emitter diffusion layer 121 and collector contact diffusion layer 123 of the PNP transistor. The diffusion at this time is performed such that the emitter-base and base-collector junctions of the NPN and PNP transistors are found under SiO₂ films 11 or 12 formed on side surfaces of emitter electrodes 9 and 117 and collector electrodes 10 and 118 (Fig. 5J). When it is necessary to provide a high junction breakdown voltage, the thickness of SiO₂ film and thermal treatment conditions have to be set to optimum values lest emitter diffusion layers 15 and 121 and collector contact diffusion layers 17 and 123 are contiguous to base contact diffusion layers 16 and 122. Further, while emitter diffusion layers 15 and 121, base contact diffusion layers 16 and 122 and collector contact diffusion layers 17 and 123 are formed by a thermal treatment at 950°C for about 40 minutes, it is possible to form emitter diffusion layers 15 and 121 and collector contact diffusion layers 17 and 123 by a thermal treatment at 950°C for about 40 minutes prior to deposition of polycrystalline silicon films of base electrodes 13 and 120, then form base electrodes 13 and 120 and then form base contact diffusion layers 16 and 122 by a thermal treatment at 900°C for about 30 minutes.

Finally, emitter, base and collector windows 18 to 20 of the NPN transistor and emitter, base and collector windows 124 to 126 of the PNP transistor are formed, and electrode leads 21 to 23 and 127 to 129 are formed to complete the semiconductor device (Fig. 5K).

As has been shown, this embodiment concerns a method of simultaneously forming NPN and PNP transistors, in which the emitter and collector electrodes of both the transistors are formed simultaneously from a common polycrystalline silicon film containing an impurity, the base contact region is defined between the polycrystalline silicon films of the emitter and collector electrodes, the emitter and collector electrodes are insulated with respect to the base electrode by an insulating film formed on top and side surfaces of polycrystalline silicon film, and the base, emitter and collector contacts are formed as self-alignment contacts. Thus, it is possible to realize a high speed, high density semiconductor device, which permits great reduction of the element area, permits reduction of the emitter-base and base-collector capacitances and base resistance has low collector-substrate capacitance and collector resistance.

Further, while in the above embodiment contact windows 18 to 20 and 124 to 129 are formed on element regions, it is possible to form these windows on isolating oxide films. Thus, the element area can be further reduced, and the junction capacitance can be further reduced (Fig. 5L).

### (Embodiment 5)

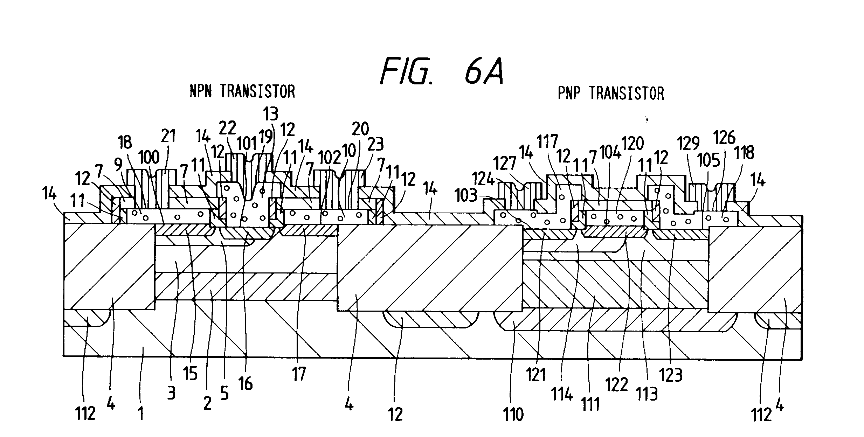

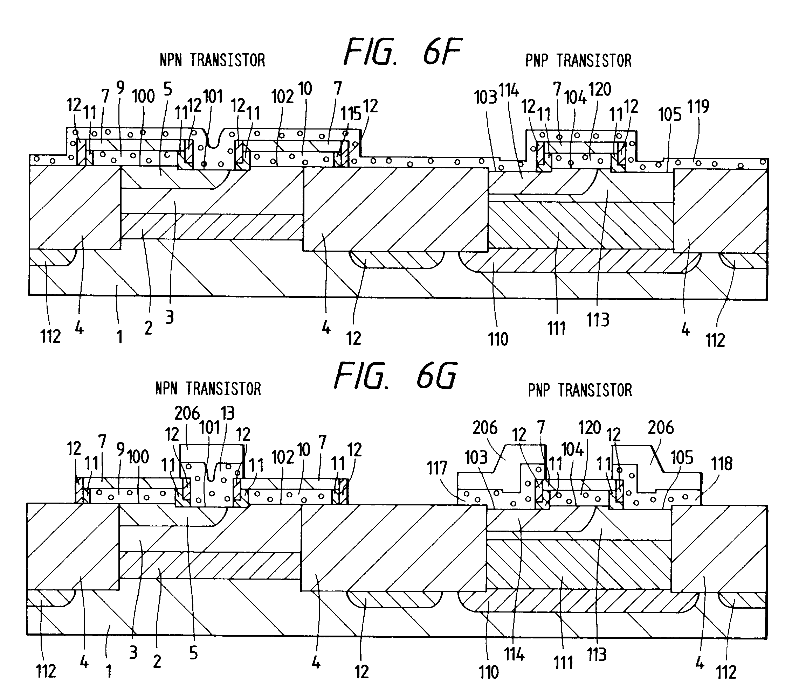

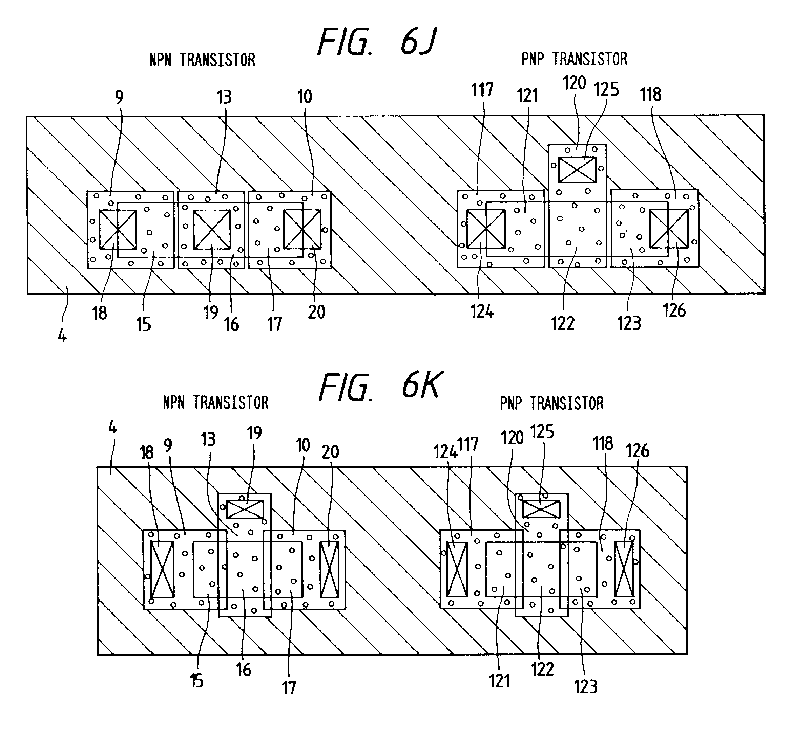

Fig. 6A shows a completed bipolar semiconductor manufactured according to Embodiment 5. Reference numerals in Fig. 6A all correspond to those indicated Fig. 5A.

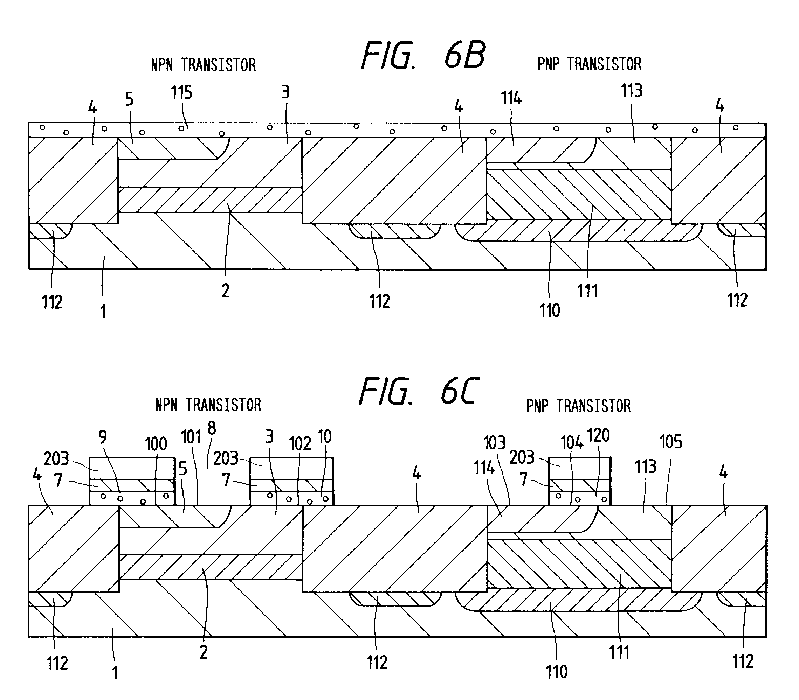

N-type buried layer 110 is formed by ion implanting phosphorus in a region of p-type (111) semiconductor substrate 1 with a resistivity of 10 to 20 Ω · cm, in which a PNP transistor is to be formed, with a resist as mask and under conditions of 80 keV and 1 x 10¹⁵/cm². Then, p-type buried layer 111 is formed by ion implantation of boron under conditions of 60 keV and 1 x 10¹⁵/cm². Then, n-type buried layer 2 is formed by ion implanting arsenic in a region, in which an NPN transistor is to be formed, with a new resist as mask and under conditions of 60 keV and 1 x 10¹⁵/cm². Then,, n-type epitaxial layer 3 with a resistivity of 1,0 Ω · cm and thickness of about 1,5 micrometres, and isolating region 4 is formed using a BOX isolating process. At this time, p-type channel stopper 112 is formed in advance under isolating region 4. Then, silicon on an island region surface surrounded by isolating region 4 is exposed, and p-type well region 113 for collector of the PNP transistor is formed by implanting boron, for instance, with a resist as mask and under conditions of 60 keV and 1,0 x 10¹⁵/cm². Then, with a new resist as mask phosphorus is ion implanted under conditions of, for instance 60 keV and 2,0 x 10¹⁵/cm² in a region, in which the PNP transistor is to be formed, thus forming base diffusion layer 114 of the PNP transistor. Then, with a new resist as mask boron is ion implanted under conditions of, for instance, 20 keV and 1,5 x 10¹⁵/cm² in an island region, in which the NPN transistor is formed, thus forming base diffusion layer 5 of the NPN transistor. Alternatively, it is possible to form a thin SiO₂ film on the island region surface, perform ion implantation through this thin SiO₂ film to form base diffusion layers 114 and 5 and then remove the thin SiO₂ film. Then, the resist is removed, and about 3000·10⁻¹⁰ m (3000-angstrom) polycrystalline silicon film 115 containing an n-type impurity, e.g., arsenic or phosphorus, by reduced pressure CVD process, for instance (Fig. 6B).
Alternatively, non-doped polycrystalline silicon film 115 may deposited, and arsenic may be ion implanted as n-type impurity into polycrystalline silicon film under conditions of 60 keV and 1 x 10¹⁵/cm².

Then, about 2500·10⁻¹⁰ m (2500-angstrom) SiO₂ film 7 is deposited by CVD process, for instance. Then, with resist 203 as mask SiO₂ film 7 and polycrystalline silicon film 115 are etched by anisotropic dry etching to form aperture in a region for base contact 101 of the NPN transistor and leave SiO₂ film 7 and polycrystalline silicon film 115 on a region for base contact 104 of the PNP transistor, while simultaneously forming polycrystalline silicon patterns of emitter and collector electrodes 9 and 10 of the NPN transistor and base electrode 120 of the PNP transistor (Fig. 6C). Thus, emitter, base and collector contacts 100 to 102 of the NPN transistor and emitter, base and collector contacts 103 to 105 of the PNP transistor are formed as self-aligned contacts.

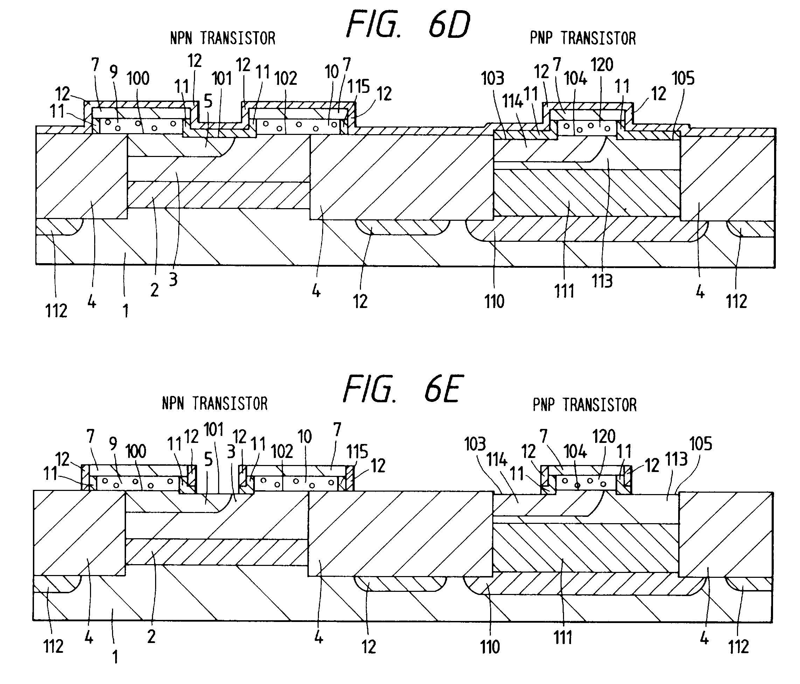

Then, resist 203 is removed, and then about 500·10⁻¹⁰ m (500-angstrom) SiO₂ film 11 is formed by oxidation at 900°C for about 30 minutes. Then, about 2000·10⁻¹⁰ m (2000-angstrom) SiO₂film 12 is formed by CVD process (Fig. 6D).

Then, SiO₂ films 11 and 12 are etched by anisotropic dry etching to leave them only on side surfaces of polycrystalline silicon films constituting emitter, collector and base electrodes 9, 10 and 120 (Fig. 6E).

Then, about 3000·10⁻¹⁰ m (3000-angstrom) polycrystalline silicon film 119 containing a p-type impurity, e.g., boron, is deposited by reduced pressure CVD process (fig. 6F). Alternatively, it is possible to deposit non-doped polycrystalline silicon film 119 and introduce a p-type impurity, e.g., boron, into the polycrystalline silicon film under conditions of 20 keV and 1 x 10¹⁵/cm².

Then polycrystalline silicon film 119 is dry etched with resist 206 as mask, thus forming base electrode 13 of the NPN transistor and emitter and collector electrodes 117 and 118 of the PNP transistor (Fig. 6C).

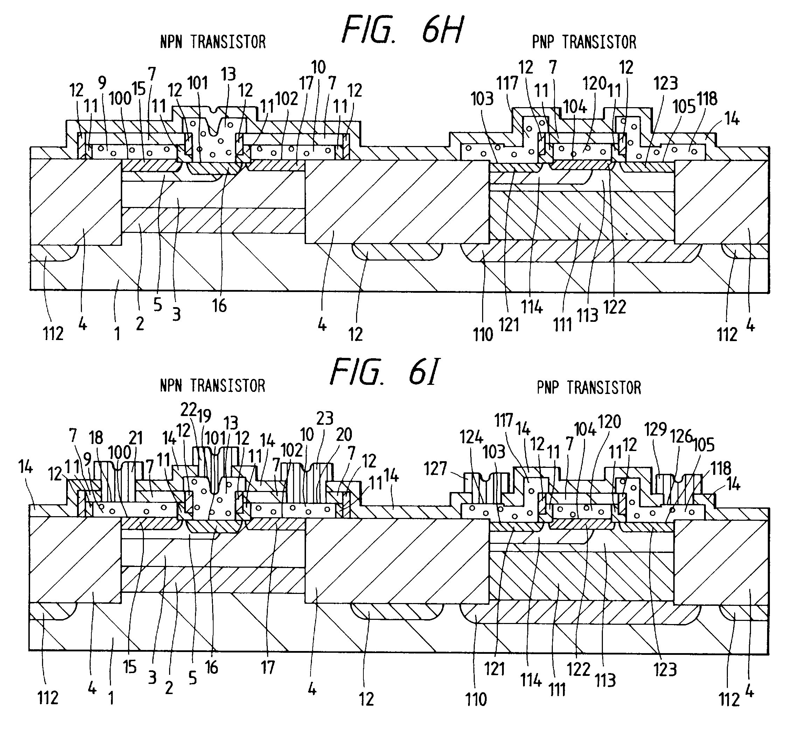

Then, resist 206 is removed, and about 2000·10⁻¹⁰ m (2000-angstrom) SiO₂ film 14 is formed by CVD process. Then, arsenic is diffused from emitter and collector electrodes 9 and 10 of the NPN transistor and base electrode 120 of the PNP transistor by a thermal treatment at 950°C for 40 minutes to form emitter diffusion layer 15 and collector contact diffusion layers 17 of the NPN transistor and base contact diffusion layer 122 of the PNP transistor. At the same time, boron is diffused from base electrode 13 of the NPN transistor and emitter and collector electrodes 117 and 118 of the PNP transistor to form base contact diffusion layer 16 of the NPN transistor and emitter diffusion layer 121 and collector contact diffusion layer 123 of the PNP transistor. The diffusion at this time is performed such that the emitter-base and base-collector junctions of the NPN and PNP transistors are found under SiO₂ film 11 or 12 formed on side surfaces of emitter electrodes 9 and 117 and collector electrodes 10 and 118 (Fig. 6H). If it is necessary to increase the junction breakdown voltage, it is necessary to set the thickness of SiO₂ film 12 and thermal treatment conditions lest emitter diffusion layers 15 and 121 and collector contact diffusion layers 17 and 123 should be contiguous to base contact diffusion layers 16 and 122. While emitter diffusion layers 15 and 121, base contact diffusion layers 16 and 122 and collector contact diffusion layers 17 and 123 are formed simultaneously by a thermal treatment at 950°C for 40 minutes, it is possible to perform a thermal treatment under conditions of, for instance, 950°C for 40 minutes prior to depositing polycrystalline silicon film for base, emitter and collector electrodes 13, 117 and 118, then form these electrodes 13, 117 and 118 and then form base contact diffusion layer 16, emitter diffusion layer 121 and collector contact diffusion layer 123 by a thermal treatment at 900°C for 30 minutes.

Finally, emitter, base and collector contact windows 18 to 20 of the NPN transistor and emitter, base and collector windows 124 to 126 of the PNP transistor, and electrode leads 21 to 23 and 127 to 129 of, e.g., aluminum are formed to complete the semiconductor device (Fig. 6I). In this case, base contact window 125 of the PNP transistor is formed on isolating region 4 (Fig. 6J).

As has been shown, this embodiment concerns a method of simultaneously forming NPN and PNP transistors, in which the emitter and collector electrodes of the NPN transistor and base electrode of the PNP transistor are formed simultaneously from the same doped polycrystalline silicon film, the base electrode of the NPN transistor and emitter and collector electrodes of the PNP transistor are formed simultaneously from the same doped polycrystalline silicon film, the emitter and collector electrodes are insulated with respect to the base electrode by an insulating film formed on top and side surfaces of the polycrystalline silicon film, and the base, emitter and collector contacts are formed as self-aligned contacts. Thus, it is possible to realize a high speed, high density semiconductor device, which permits great reduction of the element area in less steps, permits reduction of the emitter-base, base-collector capacitances and base resistance and has small collector-substrate capacitance and collector resistance.

Further, while in the above embodiment contact windows 18 to 20 and 124 and 126 are formed on element region, it is also possible to form these windows on isolating oxide film. Thus, the element area can be further reduced, and the junction capacitance can be reduced (Fig. 6K).

As has been shown, with Embodiments 1 to 5 as described the emitter and collector electrodes are formed simultaneously on the same doped polycrystalline silicon film, the base contact region is defined between the polycrystalline silicon films of the emitter and collector electrodes, the emitter and collector electrodes are insulated with respect to the base electrode, and base, emitter and collector contacts are formed as self-aligned contacts. Thus, the method according to the invention permits great reduction of the element area, permits not only reduction of the emitter-base and base-collector capacitances and base resistance but also great reduction of the collector-substrate capacitance and collector resistance and permits realization of a high speed, high density semiconductor device, and it is very useful in practice.

In addition, in Embodiment 2 the base contact and electrode lead are directly connected to each other instead of forming polycrystalline silicon film as base electrode. Therefore, it is possible to reduce the number of steps and cost, which is very useful in practice.

Further, in Embodiment 3 the emitter and collector contact diffusion layers are surrounded by an insulating film to permit further reduction of the emitter-base and base-collector capacitances and realize a high speed semiconductor device, which is very useful.

Further, in Embodiments 4 and 5 it is possible to realize a semiconductor device including high speed, high density NPN and PNP transistors, in which base, emitter and collector contacts are formed as self-aligned contacts to greatly reduce the element area and reduce the emitter-base and base-collector capacitances and base resistance. The device has furthermore low collector-substrate capacitance and collector resistance.

Further, in Embodiments 1 and 3 to 5 a high speed, high density semiconductor device can be realized, which has electrodes formed from polycrystalline silicon film, permits formation of contact windows outside the element area and permits reduction thereof.

A method of manufacturing a bipolar semiconductor device is disclosed, in which emitter, base and collector contacts are formed as self-aligned contacts. it is thus possible to realize a high speed, high density semiconductor device, which greatly reduces the element area, emitter-base, base-collector and collector-substrate capacitances and base and collector resistances.

## Claims

1. A method of fabricating a semiconductor device having a bipolar transistor, comprising the successive steps of:
forming a base layer (5) in a predetermined region in a semiconductor substrate (3) of a first conductivity type having a major surface, said base layer (5) being of a second conductivity type opposite to said first conductivity type;
forming an emitter electrode (9) and a collector electrode (10) spaced from each other on said major surface on an emitter-contact-forming region (100) of said base layer (5) and a collector-contact-forming region (102) of said semiconductor substrate (3), respectively, said emitter and collector electrodes (9, 10) having respective sides facing each other, a first insulating film (7) being provided on top of the emitter and collector electrodes (9, 10), said emitter and collector electrodes (9, 10) containing impurity corresponding to the first conductivity type;
forming a second insulating film (11, 12) simultaneously on said facing sides of said emitter and collector electrodes (9, 10) by successively forming on said facing sides an oxide film (11) by thermal oxidation and a SiO₂ film by a CVD process, thus defining a base-contact-forming region (101) extending from one to the other of said insulated facing sides at said major surface above a portion of said base layer (5);
forming a base electrode (13) containing impurity corresponding to the second conductivity type on the entire base-contact-forming region (101);
diffusing the impurity from said emitter electrode (9), said collector electrode (10), and said base electrode (13) thereby forming an emitter layer (15) of the first conductivity type, a collector contact layer (17) of the first conductivity type, and a base contact layer (16) of the second conductivity type
so that the emitter layer boundary is exposed at said major surface at a position directly below the portion of said second insulating film (11, 12) which is formed on said side of said emitter electrode (9) and
the collector contact layer boundary is exposed at said major surface at a position directly below the portion of said second insulating film (11, 12) which is formed on said side of said collector electrode (10).

2. A method of fabricating a semiconductor device having a bipolar transistor, comprising the successive steps of:
forming a base layer (5) in a predetermined region in a semiconductor substrate (3) of a first conductivity type having a major surface, said base layer (5) being of a second conductivity type opposite to said first conductivity type;
forming an emitter electrode (9) and a collector electrode (10) spaced from each other on said major surface on an emitter-contact-forming region (100) of said base layer (5) and a collector-contact-forming region (102) of said semiconductor substrate (3), respectively, said emitter and collector electrodes (9, 10) having respective sides facing each other, a first insulating film (7) being provided on top of the emitter and collector electrodes (9, 10), said emitter and collector electrodes (9, 10) containing impurity corresponding to the first conductivity type;
forming a second insulating film (11, 12) simultaneously on said facing sides of said emitter and collector electrodes (9, 10) by successively forming on said facing sides an oxide film (11) by thermal oxidation and a SiO₂ film by a CVD process, thus defining a base-contact-forming region (101) extending from one to the other of said insulated facing sides at said major surface above a portion of said base layer (5);
implanting ions corresponding to the second conductivity type into the entire base-contact-forming region (101) thereby forming a base contact layer (16) while using said first and second insulating films (7, 11, 12) as masks;
diffusing the impurity from said emitter electrode (9) and said collector electrode (10) thereby forming an emitter layer (15) and a collector contact layer (17) of the first conductivity type
so that the emitter layer boundary is exposed at said major surface at a position directly below the portion of said second insulating film (11, 12) which is formed on said side of said emitter electrode (9) and
the collector contact layer boundary is exposed at said major surface at a position directly below the portion of said second insulating film (11, 12) which is formed on said side of said collector electrode (10).

3. The method of any one of claims 1 or 2 wherein said emitter layer (15) and said base contact layer (16) are formed not directly contacting with each other.

4. The method of any one of claims 1 or 2 wherein said collector contact layer (17) and said base contact layer (16) are formed not directly contacting with each other.

5. The method of claim 1 further comprising the step of etching the region of said semiconductor substrate (3) located between said emitter electrode (9) and said collector electrode (10), thereby forming a groove (208) in said semiconductor substrate (3), before the step of forming said second insulating film (11, 12),
wherein the bottom of said groove (208) is located at a position lower than a bottom surface of the emitter layer (15) to be formed and at
a position higher than a bottom surface of said base layer (5).

6. The method of claim 1 or of any one of claims 3 or 4 where dependent on claim 1, or the method of claim 5 further comprising the step of forming said emitter electrode (9), said collector electrode (10), and said base electrode (13) from polycrystalline silicon.

7. The method of claim 2 or of any one of claims 3 or 4 where dependent on claim 2, further comprising the step of forming said emitter electrode (9) and said collector electrode (10) from polycrystalline silicon.

8. A method of fabricating a semiconductor device including an NPN bipolar transistor and a PNP bipolar transistor, comprising the successive steps of:
forming a well region (113) in a first predetermined region in a semiconductor substrate (3) of a first conductivity type having a major surface, said well region (113) being of a second conductivity type opposite to said first conductivity type;
forming a first base layer (114) of the first conductivity type in said well region (113);
forming a second base layer (5) of the second conductivity type in a second predetermined region in said semiconductor substrate (3);
forming a first polycrystalline silicon film (115) on said semiconductor substrate (3), extending above said first and second predetermined regions;
introducing impurity corresponding to the first conductivity type into a portion of said first polycrystalline silicon film (115) which extends above said second predetermined region;
introducing impurity corresponding to the second conductivity type into the portion of said first polycrystalline silicon film (115) which extends above said first predetermined region;
forming a first insulating film (7) on said first polycrystalline silicon film (115);
etching said first insulating film (7) and said first polycrystalline silicon film (115), thereby simultaneously forming on said major surface a first emitter electrode (117) and a first collector electrode (118) spaced from each other on a respective emitter-contact-forming region (103) of said first base layer (114) and a respective collector-contact-forming region (105) of said well region (113), and a second emitter electrode (9) and a second collector electrode (10) spaced from each other on a respective emitter-contact-forming region (100) of said second base layer (5) and a respective collector-contact-forming region (102) of said semiconductor substrate (3), said first emitter and collector electrodes having respective sides facing each other, and said second emitter and collector electrodes having respective sides facing each other;
forming a second insulating film (11, 12) simultaneously on said facing sides of the emitter and collector electrodes (9, 117, 10, 118) by successively forming on said facing sides on oxide film (11) by thermal oxidation and a SiO₂ film by a CVD process, thus defining first and second base-contact-forming regions (104, 101) extending from one to the other of said facing sides of said first and second emitter and collector electrodes (117, 118, 9, 10) at said major surface above respective portions of said first and second base layers (114, 5);
forming a second polycrystalline silicon film (119) on said semiconductor substrate (3) on the entire first and second base-contact-forming regions (104, 101);
introducing impurity corresponding to the second conductivity type into the portion of said second polycrystalline silicon film (119) which extends above said second base-contact-forming region (101);
introducing impurity corresponding to the first conductivity type into the portion of said second polycrystalline silicon film (119) which extends above said first base-contact-forming region (104);
etching said second polycrystalline silicon film (119) thereby simultaneously forming on said major surface a base electrode (13) of the NPN transistor and a separate base electrode (120) of the PNP transistor, each base electrode being formed on a respective entire base-contact-forming region;
diffusing the impurity from said emitter electrodes (9, 117), said collector electrodes (10, 118), and said base electrodes (13, 120) thereby forming emitter layers (15, 121), collector contact layers (17, 123), and base contact layers (16, 122) of the NPN transistor and the PNP transistor
so that the emitter layer boundary is exposed at said major surface at a position directly below the portion of said second insulating film (11, 12) which is formed on said side of said emitter electrode (9, 117) in each of the NPN transistor and the PNP transistor and the collector contact layer boundary is exposed at said major surface at a position directly below the portion of said second insulating film (11, 12) which is formed on said side of said collector electrode (10, 118) in each of the NPN transistor and the PNP transistor.

9. The method of claim 8 wherein said emitter layer (15, 121) and said base contact layer (16, 122) are formed not directly contacting with each other in each of the NPN transistor and the PNP transistor.

10. The method of claim 8 wherein said collector contact layer (17, 123) and said base contact layer (16, 122) are formed not directly contacting with each other in each of the NPN transistor and the PNP transistor.

11. A method of fabricating a semiconductor device including an NPN bipolar transistor and a PNP bipolar transistor, comprising the successive steps of:
forming a well region (113) in a first predetermined region in a semiconductor substrate (3) of a first conductivity type having a major surface, said well region (113) being of a second conductivity type opposite to said first conductivity type;
forming a first base layer (114) of the first conductivity type in said well region (113);
forming a second base layer (5) of the second conductivity type in a second predetermined region in said semiconductor substrate (3);
forming a first polycrystalline silicon film (115) on said semiconductor substrate (3), extending above said first and second predetermined regions, said first polycrystalline silicon film (115) including impurity corresponding to the first conductivity type;
forming a first insulating film (7) on said first polycrystalline silicon film (115);
etching said first insulating film (7) and said first polycrystalline silicon film (115), thereby simultaneously forming on said major surface a first base electrode (120) on a first base-contact-forming region (104) of said first base layer (114), said first base electrode (120) having side surfaces, and a first emitter electrode (9) and a first collector electrode (10) spaced from each other on a respective emitter-contact-forming region (100) of said second base layer (5) and a respective collector-contact-forming region (102) of said semiconductor substrate (3), said first emitter and collector electrodes having respective sides facing each other;
forming a second insulating film (11, 12) simultaneously on said side surfaces of said first base electrode (120) and on said facing sides of said first emitter and collector electrodes (9, 10) by successively forming on said side surfaces and said facing sides an oxide film (11) by thermal oxidation and a SiO₂ film by a CVD process, thus defining a second base-contact-forming region (101) extending from one to the other of said facing sides of said first emitter and collector electrodes (9, 10) at said major surface above a portion of said second base layer (5);
forming a second polycrystalline silicon film (119) on said semiconductor substrate (3) on the entire second base-contact-forming region (101) and above said first predetermined region;
introducing impurity corresponding to the second conductivity type into said second polycrystalline silicon film (119);
etching said second polycrystalline silicon film (119) so as to simultaneously form on said major surface a second base electrode (13) on the entire second base-contact-forming region (101), and second separate emitter and collector electrodes (117, 118) on a respective emitter-contact-forming region (103) of said first base layer (114) and a respective collector-contact-forming region (105) of said well region (113);
diffusing the impurity from said emitter electrodes (9, 117), said collector electrodes (10, 118), and said base electrodes (13, 120) thereby forming emitter layers (15, 121), collector contact layers (17, 123), and base contact layers (16, 122) of the NPN transistor and the PNP transistor
so that the emitter layer boundary is exposed at said major surface at a position directly below the portion of said second insulating film (11, 12) which is formed on said side of said emitter electrode (9, 117) in each of the NPN transistor and the PNP transistor and the collector contact layer boundary is exposed at said major surface at a position directly below the portion of said second insulating film (11, 12) which is formed on said side of said collector electrode (10, 118) in each of the NPN transistor and the PNP transistor.

12. The method of claim 11 wherein said emitter layer (15, 121) and said base contact layer (16, 122) are formed not directly contacting with each other in each of the NPN transistor and the PNP transistor.

13. The method of claim 11 wherein said collector contact layer (17, 123) and said base contact layer (16, 122) are formed not directly contacting with each other in each of the NPN transistor and the PNP transistor.

## Patentansprüche

1. Verfahren zur Herstellung einer Halbleitervorrichtung mit einem bipolaren Transistor, umfassend die aufeinanderfolgenden Schritte:
Bildung einer Basisschicht (5) in einem vorbestimmten Bereich in einem Halbleitersubstrat (3) des ersten Leitungstyps mit einer großen Oberfläche, wobei die Basisschicht (5) aus einem zweiten Leitungstyp besteht, welcher dem ersten Leitungstyp entgegengesetzt ist;
Bildung einer Emitter-Elektrode (9) und einer Kollektor-Elektrode (10), welche jeweils auf der großen Oberfläche voneinander entfernt auf einem Emitter-Kontaktbildungsbereich (100) der Basisschicht (5) sowie einem Kollektor-Kontaktbildungsbereich (102) des Halbleitersubstrats (3) angeordnet sind, wobei die Emitter- und Kollektor-Elektroden (9, 10) jeweils sich gegenüberliegende Seiten haben, wobei ein erster Isolationsfilm (7) auf den Emitter- und Kollektor-Elektroden (9, 10) bereitgestellt ist, wobei die Emitter- und Kollektor-Elektroden (9, 10) eine Verunreinigung enthalten, welche dem ersten Leitungstyp entspricht;
Bildung eines zweiten Isolationsfilms (11, 12) gleichzeitig auf den sich gegenüberliegenden Seiten der Emitter- und Kollektor-Elektroden (9, 10) durch aufeinanderfolgende Bildung eines Oxidfilm (11) durch thermische Oxidation und eines SiO₂-Films durch ein CVD-Verfahren auf den gegenüberliegenden Seiten, wodurch ein Basis-Kontaktbildungsbereich (101) festgelegt wird, welcher sich von der einen zur anderen der sich gegenüberliegenden isolierten Seiten auf der großen Oberfläche oberhalb eines Abschnitts der Basisschicht (5) erstreckt; Bildung einer Basis-Elektrode (13), welche eine Verunreinigung enthält, die dem zweiten Leitungstyp entspricht, auf dem gesamten Basis-Kontaktbildungsbereich (101);
Diffusion der Verunreinigung von der Emitter-Elektrode (9), der Kollektor-Elektrode (10), und der Basis-Elektrode (13), wodurch eine Emitter-Schicht (15) des ersten Leitungstyps, eine Kollektor-Kontaktschicht (17) des ersten Leitungstyps, sowie eine Basis-Kontaktschicht (16) des zweiten Leitungstyps gebildet wird,
so daß die Grenze der Emitter-Schicht an der großen Oberfläche an einer Position direkt unterhalb des Abschnitts des zweiten Isolationsfilms (11, 12), welcher auf der Seite der Emitter-Elektrode (9) gebildet ist, freigelegt ist, und
die Grenze der Kollektor-Kontaktschicht an der großen Oberfläche an einer Position direkt unterhalb des Abschnitts des zweiten Isolationsfilms (11, 12), welcher auf der Seite der Kollektor-Elektrode (10) gebildet ist, freigelegt ist.

2. Verfahren zur Herstellung einer Halbleitervorrichtung mit einem bipolaren Transistor, umfassend die aufeinanderfolgenden Schritte:
Bildung einer Basisschicht (5) in einem vorbestimmten Bereich in einem Halbleitersubstrat (3) des ersten Leitungstyps mit einer großen Oberfläche, wobei die Basisschicht (5) aus einem zweiten Leitungstyp besteht, welcher dem ersten Leitungstyp entgegengesetzt ist;
Bildung einer Emitter-Elektrode (9) und einer Kollektor-Elektrode (10), welche jeweils auf der großen Oberfläche voneinander entfernt auf einem Emitter-Kontaktbildungsbereich (100) der Basisschicht (5) sowie einem Kollektor-Kontaktbildungsbereich (102) des Halbleitersubstrats (3) angeordnet sind, wobei die Emitter- und Kollektor-Elektroden (9, 10) jeweils sich gegenüberliegende Seiten haben, wobei ein erster Isolationsfilm (7) auf den Emitter- und Kollektor-Elektroden (9, 10) bereitgestellt ist, wobei die Emitter- und Kollektor-Elektroden (9, 10) eine Verunreinigung enthalten, welche dem ersten Leitungstyp entspricht;
Bildung eines zweiten Isolationsfilms (11, 12) gleichzeitig auf den sich gegenüberliegenden Seiten der Emitter- und Kollektor-Elektroden (9, 10) durch aufeinanderfolgende Bildung eines Oxidfilm (11) durch thermische Oxidation und eines SiO₂-Films durch ein CVD-Verfahren auf den gegenüberliegenden Seiten, wodurch ein Basis-Kontaktbildungsbereich (101) festgelegt wird, welcher sich von der einen zur anderen der sich gegenüberliegenden isolierten Seiten auf der großen Oberfläche oberhalb eines Abschnitts der Basisschicht (5) erstreckt; Implantation von Ionen entsprechend dem zweiten Leitungstyp in den gesamten Basis-Kontaktbildungsbereich (101), wodurch eine Basis-Kontaktschicht (16) unter Verwendung der ersten und zweiten Isolationsfilme (7, 11, 12) als Masken gebildet wird;
Diffusion der Verunreinigung aus der Emitter-Elektrode (9) und der Kollektor-Elektrode (10), wodurch eine Emitter-Schicht (15) und eine Kollektor-Kontaktschicht (17) des ersten Leitungstyps gebildet werden,
so daß die Grenze der Emitter-Schicht an der großen Oberfläche an einer Position direkt unterhalb des Abschnitts des zweiten Isolationsfilms (11, 12), welcher auf der Seite der Emitter-Elektrode (9) gebildet ist, freigelegt ist, und die Grenze der Kollektor-Kontaktschicht an der großen Oberfläche an einer Position direkt unterhalb des Abschnitts des zweiten Isolationsfilms (11, 12), welche auf der Seite der Kollektor-Elektrode (10) gebildet ist, freigelegt ist.

3. Verfahren nach einem der Ansprüche 1 oder 2, wobei die Emitter-Schicht (15) und die Basis-Kontaktschicht (16) so gebildet sind, daß sie nicht direkt miteinander in Kontakt stehen.

4. Verfahren nach einem der Ansprüche 1 oder 2, wobei die Kollektor-Kontaktschicht (17) und die Basis-Kontaktschicht (16) so gebildet sind, daß sie nicht direkt miteinander in Kontakt stehen.

5. Verfahren nach Anspruch 1, welches weiterhin den Schritt der Verätzung des Bereichs des Halbleitersubstrats (3), welcher zwischen der Emitter-Elektrode (9) und der Kollektor-Elektrode (10) angeordnet ist, wodurch eine Rinne (208) in dem Halbleitersubstrat (3) gebildet wird, vor dem Schritt der Bildung des zweiten Isolationsfilms (11, 12) umfaßt, wobei der Boden der Rinne (208) an einer Position angeordnet ist, welche tiefer als eine untere Oberfläche der zu bildenden Emitter-Schicht (15) und höher als eine untere Oberfläche der Basis-Schicht (5) liegt.

6. Verfahren nach irgendeinem der Ansprüche 1 und 3 bis 5, welches weiterhin den Schritt der Bildung der Emitter-Elektrode (9), der Kollektor-Elektrode (10), und der Basis-Elektrode (13) aus polykristallinem Silicium umfaßt.

7. Verfahren nach einem der Ansprüche 2 bis 4, welches weiterhin den Schritt der Bildung der Emitter-Elektrode (9) und der Kollektor-Elektrode (10) aus polykristallinem Silicium umfaßt.

8. Verfahren zur Herstellung einer Halbleitervorrichtung einschließlich einem bipolaren NPN-Transistor und einem bipolaren PNP-Transistor, umfassen die aufeinanderfolgenden Schritte:
Bildung eines Wannenbereichs (113) in einem ersten vorbestimmten Bereich in einem Halbleitersubstrat (3) eines ersten Leitungstyps mit einer großen Oberfläche, wobei der Wannenbereich (113) aus dem zum ersten Leitungstyp entgegengesetzten zweiten Leitungstyp besteht;
Bildung einer ersten Basis-Schicht (114) des ersten Leitungstyps in dem Wannenbereich (113);
Bildung einer zweiten Basis-Schicht (5) des zweiten Leitungstyps in einem zweiten vorbestimmten Bereich in dem Halbleitersubstrat (3);
Bildung eines ersten polykristallinen Siliciumfilms (115) auf dem Halbleitersubstrat (3), welcher sich oberhalb der ersten und zweiten vorbestimmten Bereiche erstreckt;
Einführung einer Verunreinigung entsprechend dem ersten Leitungstyp in einen Abschnitt des ersten polykristallinen Siliciumfilms (115), welcher sich oberhalb des zweiten vorbestimmten Bereichs erstreckt;
Einführung einer Verunreinigung entsprechend dem zweiten Leitungstyp in den Abschnitt des ersten polykristallinen Siliciumfilms (115), welcher sich oberhalb des ersten vorbestimmten Bereichs erstreckt;
Bildung eines ersten Isolationsfilms (7) auf dem ersten polykristallinen Siliciumfilm (115);
Ätzen des ersten Isolationsfilms (7) und des ersten polykristallinen Siliciumfilms (115), wodurch gleichzeitig voneinander entfernt auf der großen Oberfläche eine erste Emitter-Elektrode (117) und eine erste Kollektor-Elektrode (118) auf einem entsprechenden Emitter-Kontaktbildungsbereich (103) der ersten Basis-Schicht (114) und einem entsprechenden Kollektor-Kontaktbildungsbereich (105) des Wannenbereichs (113) gebildet werden, und eine zweite Emitter-Elektrode (9) und eine zweite Kollektor-Elektrode (10) voneinander entfernt auf einem entsprechenden Emitter-Kontaktbildungsbereich (100) der zweiten Basis-Schicht (5) und einem entsprechenden Kollektor-Kontaktbildungsbereich (102) des Halbleitersubstrats (3) gebildet werden, wobei die ersten Emitter- und Kollektor-Elektroden entsprechende sich gegenüberliegende Seiten haben, und die zweiten Emitter- und Kollektor-Elektroden entsprechende sich gegenüberliegende Seiten haben;
Bildung eines zweiten Isolationsfilms (11, 12) gleichzeitig auf den sich gegenüberliegenden Seiten der Emitter- und Kollektor-Elektroden (9, 117, 10, 118) durch aufeinanderfolgende Bildung eines Oxidfilms (11) durch thermische Oxidation und eines SiO2-Films durch ein CVD-Verfahren, wodurch erste und zweite Basis-Kontaktbildungsbereiche (104, 101) festgelegt werden, welche sich von einer zur anderen der sich gegenüberliegenden Seiten der ersten und zweiten Emitter- und Kollektor-Elektroden (117, 118, 9, 10) auf der großen Oberfläche oberhalb entsprechender Abschnitte der ersten und zweiten Basis-Schichten (114, 5) erstrecken;
Bildung eines zweiten polykristallinen Siliciumfilms (119) auf dem Halbleitersubstrat (3) auf den gesamten ersten und zweiten Basis-Kontaktbildungsbereichen (104, 101); Einführung einer Verunreinigung entsprechend dem zweiten Leitungstyp in den Abschnitt des zweiten polykristallinen Siliciumfilms (119), welcher sich oberhalb des zweiten Basis-Kontaktbildungsbereichs (101) erstreckt;
Einführung einer Verunreinigung entsprechend dem ersten Leitungstyp in den Abschnitt des zweiten polykristallinen Siliciumfilms (119), welcher sich oberhalb des ersten Basis-Kontaktbildungsbereichs (104) erstreckt;
Ätzen des zweiten polykristallinen Siliciumfilms (119), wodurch gleichzeitig auf der großen Oberfläche eine Basis-Elektrode (13) des NPN-Transistors sowie eine getrennte Basis-Elektrode (120) des PNP-Transistors gebildet werden, wobei jede Basis-Elektrode auf einem entsprechenden gesamten Basis-Kontaktbildungsbereich gebildet ist;
Diffusion der Verunreinigung aus den Emitter-Elektroden (9, 117), den Kollektor-Elektroden (10, 118), und den Basis-Elektroden (13, 120), wodurch Emitter-Schichten (15, 121), Kollektor-Kontaktschichten (17, 123), sowie Basis-Kontaktschichten (16, 122) des NPN-Transistors und des PNP-Transistors gebildet werden,
so daß die Grenze der Emitter-Schicht an der großen Oberfläche an einer Position direkt unterhalb des Abschnitts des zweiten Isolationsfilms (11, 12), welcher auf der Seite der Emitter-Elektrode (9, 117) in jeweils dem NPN-Transistor und dem PNP-Transistor gebildet ist, freigelegt ist, und die Grenze der Kollektor-Kontaktschicht an der großen Oberfläche an einer Position direkt unterhalb des Abschnitts des zweiten Isolationsfilms (11, 12), welcher auf der Seite der Kollektor-Elektrode (10, 118) in jeweils dem NPN-Transistor und dem PNP-Transistor gebildet ist, freigelegt ist.

9. Verfahren nach Anspruch 8, wobei die Emitter-Schicht (15, 121) und die Basis-Kontaktschicht (16, 122) so gebildet sind, daß sie in jeweils dem NPN-Transistor und dem PNP-Transistor nicht direkt miteinander in Kontakt stehen.

10. Verfahren nach Anspruch 8, wobei die Kollektor-Kontaktschicht (17, 123) und die Basis-Kontaktschicht (16, 122) so gebildet sind, daß sie in jeweils dem NPN-Transistor und dem PNP-Transistor nicht direkt miteinander in Kontakt stehen.

11. Verfahren zur Herstellung einer Halbleitervorrichtung einschließlich einem bipolaren NPN-Transistor und einem bipolaren PNP-Transistor, umfassend die aufeinanderfolgenden Schritte:
Bildung eines Wannenbereichs (113) in einem ersten vorbestimmten Bereich in einem Halbleitersubstrat (3) eines ersten Leitungstyps mit einer großen Oberfläche, wobei der Wannenbereich (113) aus einem zweiten Leitungstyp entgegengesetzt zum ersten Leitungstyp besteht;
Bildung einer ersten Basis-Schicht (114) des ersten Leitungstyps in dem Wannenbereich (113);
Bildung einer zweiten Basis-Schicht (5) des zweiten Leitungstyps in einem zweiten vorbestimmten Bereich in dem Halbleitersubstrat (3);
Bildung eines ersten polykristallinen Siliciumfilms (115) auf dem Halbleitersubstrat (3), welcher sich oberhalb der ersten und zweiten vorbestimmten Bereiche erstreckt, wobei der erste polykristalline Siliciumfilm (115) eine Verunreinigung entsprechend dem ersten Leitungstyp einschließt;
Bildung eines ersten Isolationsfilms (7) auf dem ersten polykristallinen Siliciumfilm (115);
Ätzen des ersten Isolationsfilms (7) und des ersten polykristallinen Siliciumfilms (115), wodurch gleichzeitig auf der großen Oberfläche eine erste Basis-Elektrode (120) auf einem ersten Basis-Kontaktbildungsbereich (104) der ersten Basis-Schicht (114), wobei die erste Basis-Elektrode (120) Seitenoberflächen hat, und eine erste Emitter-Elektrode (9) und eine erste Kollektor-Elektrode (10) voneinander entfernt auf einem entsprechenden Emitter-Kontaktbildungsbereich (100) der zweiten Basis-Schicht (5) und einem entsprechenden Kollektor-Kontaktbildungsbereich (102) des Halbleitersubstrats (3) gebildet werden, wobei die ersten Emitter- und Kollektor-Elektroden entsprechende sich gegenüberliegende Seiten haben;
Bildung eines zweiten Isolationsfilms (11, 12) gleichzeitig auf den Seitenoberflächen der ersten Basis-Elektrode (120) und auf den sich gegenüberliegenden Seiten der ersten Emitter- und Kollektor-Elektroden (9, 10) durch aufeinanderfolgende Bildung eines Oxidfilms (11) durch thermische Oxidation und eines SiO₂-Films durch ein CVD-Verfahren auf den Seitenoberflächen und den sich gegenüberliegenden Seiten, wodurch ein zweiter Basis-Kontaktbildungsbereich (101) festgelegt wird, welcher sich von der einen zur anderen der sich gegenüberliegenden Seiten der ersten Emitter- und Kollektor-Elektroden (9, 10) auf der großen Oberfläche oberhalb eines Abschnitts der zweiten Basis-Schicht (5) erstreckt;
Bildung eines zweiten polykristallinen Siliciumfilms (119) auf dem Halbleitersubstrat (3) auf dem gesamten zweiten Basis-Kontaktbildungsbereich (101) und oberhalb des ersten vorbestimmten Bereichs;
Einführung einer Verunreinigung entsprechend dem zweiten Leitungstyp in den zweiten polykristallinen Siliciumfilm (119); Ätzen des zweiten polykristallinen Siliciumfilms (119), um so gleichzeitig auf der großen Oberfläche eine zweite Basis-Elektrode (13) auf dem gesamten zweiten Basis-Kontaktbildungsbereich (101) sowie zweite getrennte Emitter- und Kollektor-Elektroden (117, 118) auf einem entsprechenden Emitter-Kontaktbildungsbereich (103) der ersten Basis-Schicht (114) und einem entsprechenden Kollektor-Kontaktbildungsbereich (105) des Wannenbereichs (113) zu bilden;
Diffusion der Verunreinigung aus den Emitter-Elektroden (9, 117), den Kollektor-Elektroden (10, 118) und den Basis-Elektroden (13, 120), wodurch Emitter-Schichten (15, 121), Kollektor-Kontaktschichten (17, 123) und Basis-Kontaktschichten (16,122) des NPN-Transistors und des PNP-Transistors gebildet werden,
so daß die Grenze der Emitter-Schicht auf der großen Oberfläche an einer Position direkt unterhalb des Abschnitts des zweiten Isolationsfilms (11, 12), welcher auf der Seite der Emitter-Elektrode (9, 117) in jeweils dem NPN-Transistor und dem PNP-Transistor gebildet ist, und die Grenze der Kollektor-Kontaktschicht auf der großen Oberfläche an einer Position direkt unterhalb des Abschnitts des zweiten Isolationsfilms (11, 12), welcher auf der Seite der Kollektor-Elektrode (10, 118) in jeweils dem NPN-Transistor und dem PNP-Transistor gebildet ist, freigelegt ist.

12. Verfahren nach Anspruch 11, wobei die Emitter-Schicht (15, 121) und die Basis-Kontaktschicht (16, 122) so gebildet sind, daß sie in jeweils dem NPN-Transistor und dem PNP-Transistor nicht direkt miteinander in Kontakt stehen.

13. Verfahren nach Anspruch 11, wobei die Kollektor-Kontaktschicht (17, 123) und die Basis-Kontaktschicht (16, 122) so gebildet sind, daß sie in jeweils dem NPN-Transistor und dem PNP-Transistor nicht direkt miteinander in Kontakt stehen.

## Revendications

1. Procédé de fabrication d'un dispositif à semi-conducteurs comportant un transistor bipolaire, comprenant les étapes successives de:
formation d'une couche de base (5) dans une région prédéterminée d'un substrat semi-conducteur (3) d'un premier type de conductivité comportant une surface principale, ladite couche de base (5) étant d'un second type de conductivité opposé audit premier type de conductivité;
formation d'une électrode d'émetteur (9) et d'une électrode de collecteur (10) espacées l'une de l'autre sur ladite surface principale d'une région (100) de formation de contact de collecteur de ladite couche de base (5) et une région (102) de formation de contact de collecteur dudit substrat semi-conducteur (3), respectivement, lesdites électrodes d'émetteur et de collecteur (9, 10) ayant des côtés respectifs en regard l'un de l'autre, un premier film isolant (7) étant disposé sur le dessus des électrodes d'émetteur et de collecteur (9, 10), lesdites électrodes d'émetteur et de collecteur (9, 10) contenant une impureté correspondant au premier type de conductivité;
formation d'un deuxième film isolant (11, 12) simultanément sur lesdits côtés, en regard l'un de l'autre, desdites électrodes d'émetteur et de collecteur (9, 10) par formation successivement sur lesdits côtés, en regard l'un de l'autre, d'un film d'oxyde (11) par oxydation thermique et d'un film de SiO₂ par un procédé de dépôt chimique en phase vapeur (procédé CVD), en définissant ainsi une région de formation de contact de base (101) s'étendant de l'un à l'autre desdits côtés isolés, en regard l'un de l'autre, au niveau de ladite surface principale au-dessus d'une partie de ladite couche de base (5);
formation d'une électrode de base (13) contenant une impureté, correspondant au second type de conductivité, sur la région entière (101) de formation de contact de base;
diffusion de l'impureté à partir de ladite électrode d'émetteur (9), de ladite électrode de collecteur (10) et de ladite électrode de base (13), en formant ainsi une couche d'émetteur (15) du premier type de conductivité, une couche (17) de contact de collecteur du premier type de conductivité, et une couche (16) de contact de base du second type de conductivité,
de sorte que la zone limite de la couche d'émetteur est exposée, au niveau de ladite surface principale et à un endroit situé directement en dessous de la partie dudit deuxième film isolant (11, 12) qui est formée sur ledit côté de ladite électrode d'émetteur (9) et
la zone limite de la couche de contact de collecteur est exposée, au niveau de ladite surface principale et à un endroit situé directement en dessous de la partie dudit deuxième film isolant (11, 12) qui est formée sur ledit côté de ladite électrode de collecteur (10).

2. Procédé de fabrication d'un dispositif à semi-conducteurs comportant un transistor bipolaire, comprenant les étapes successives de:
formation d'une couche de base (5) dans une région prédéterminée d'un substrat semi-conducteur (3) d'un premier type de conductivité, comportant une surface principale, ladite couche de base (5) étant d'un second type de conductivité opposé audit premier type de conductivité;
formation d'une électrode d'émetteur (9) et d'une électrode de collecteur (10) espacées l'une de l'autre sur ladite surface principale d'une région (100) de formation de contact d'émetteur de ladite couche de base (5) et une région (102) de formation de contact de collecteur dudit substrat semi-conducteur (3), respectivement, lesdites électrodes d'émetteur et de collecteur (9, 10) ayant des côtés respectifs en regard l'un de l'autre, un premier film isolant (7) étant disposé sur le dessus des électrodes d'émetteur et de collecteur (9 10), lesdites électrodes d'émetteur et de collecteur (9, 10) contenant une impureté correspondant au premier type de conductivité;
formation d'un deuxième film isolant (11, 12) simultanément sur lesdits côtés en regard l'un de l'autre desdites électrodes d'émetteur et de collecteur (9, 10) par formation successivement sur lesdits côtés, en regard l'un de l'autre, d'un film d'oxyde (11) et d'un film de SiO₂ par un procédé de dépôt chimique en phase vapeur (procédé CVD), en définissant ainsi une région de formation de contact de base (101) s'étendant de l'un à l'autre desdits côtés isolés, en regard l'un de l'autre, au niveau de ladite surface principale au-dessus d'une partie de ladite couche de base (5);
implantation d'ions, correspondant au second type de conductivité, dans la région entière (101) de formation de contact de base, en formant ainsi une couche (16) de contact de base tout en utilisant lesdits premier et deuxième films isolants (7, 11, 12) comme masques;
diffusion de l'impureté à partir de ladite électrode d'émetteur (9) et de ladite électrode de collecteur (10), en formant ainsi une couche d'émetteur (15) et une couche (17) de contact de collecteur du premier type de conductivité,
de sorte que la zone limite de la couche d'émetteur est exposée, au niveau de ladite surface principale et à un endroit situé directement en dessous de la partie dudit deuxième film isolant (11, 12) qui est formée sur ledit côté de ladite électrode d'émetteur (9) et
la zone limite de la couche de contact de collecteur est exposée, au niveau de ladite surface principale et à un endroit situé directement en dessous de la partie dudit deuxième film isolant (11, 12) qui est formée sur ledit côté de ladite électrode de collecteur (10).

3. Procédé selon l'une des revendications 1 ou 2, dans lequel ladite couche d'émetteur (15) et ladite couche (16) de contact de base sont formées de manière à ne pas être directement en contact l'une avec l'autre.

4. Procédé selon l'une des revendication 1 ou 2, dans lequel ladite couche (17) de contact de collecteur et ladite couche (16) de contact de base sont formées de manière à ne pas être directement en contact l'une avec l'autre.

5. Procédé selon la revendication 1, comprenant, en outre, l'étape de gravure de la région dudit substrat semi-conducteur (3) située entre ladite électrode d'émetteur (9) et ladite électrode de collecteur (10), en formant ainsi une rainure (208) dans ledit substrat semi-conducteur (3) avant l'étape de formation dudit deuxième film isolant (11, 12),
le fond de ladite rainure (208) se trouvant à une position située plus bas que la position de la surface inférieure de la couche d'émetteur (15) qui doit être formée et à une position située plus haut que la position de la surface inférieure de ladite couche de base.

6. Procédé selon la revendication 1 ou n'importe laquelle des revendications 3 ou 4 pour autant qu'elles sont rattachées à la revendication 1, ou procédé selon la revendication 5 comprenant, en outre, l'étape de formation de ladite électrode d'émetteur (9), de ladite électrode de collecteur (10) et de ladite électrode de base (13) à partir d'un silicium polycristallin.

7. Procédé selon la revendication 2 ou n'importe laquelle des revendications 3 ou 4, pour autant qu'elles sont rattachées à la revendication 2, comprenant, en outre, l'étape de formation de ladite électrode d'émetteur (9) et de ladite électrode de collecteur (10) à partir d'un silicium polycristallin.

8. Procédé de fabrication d'un dispositif à semi-conducteurs comprenant un transistor bipolaire NPN et un transistor bipolaire PNP, comprenant les étapes successives de:
formation d'une région de caisson (113) dans une première région prédéterminée d'un substrat semi-conducteur (3) d'un premier type de conductivité comportant une surface principale, ladite région de caisson (113) étant d'un second type de conductivité opposé audit premier type de conductivité;
formation d'une première couche de base (114) du premier type de conductivité dans ladite région de caisson (113);
formation d'une deuxième couche de base (5) du second type de conductivité dans une deuxième région prédéterminée dudit substrat semi-conducteur (3);
formation d'un premier film (115) de silicium polycristallin sur ledit substrat semi-conducteur (3), ce film s'étendant au-dessus desdites première et deuxième régions prédéterminées;
introduction d'une impureté correspondant au premier type de conductivité dans une partie dudit premier film (115) de silicium polycristallin qui s'étend au-dessus de ladite deuxième région prédéterminée;
introduction d'une impureté correspondant au second type de conductivité dans la partie dudit premier film (115) de silicium polycristallin qui s'étend au-dessus de ladite première région prédéterminée;
formation d'un premier film isolant (7) sur ledit premier film (115) de silicium polycristallin;
gravure dudit premier film isolant (7) et dudit premier film (115) de silicium polycristallin, en formant ainsi simultanément, sur ladite surface principale, une première électrode d'émetteur (117) et une première électrode de collecteur (118) espacées l'une de l'autre sur une région respective (103) de formation de contact d'émetteur de ladite première couche de base (114) et une région respective (105) de formation de contact de collecteur de ladite région de caisson (113), ainsi qu'une deuxième électrode d'émetteur (9) et une deuxième électrode de collecteur (10) espacées l'une de l'autre sur une région respective (100) de formation de contact d'émetteur de ladite deuxième couche de base (5) et une région respective (102) de formation de contact de collecteur dudit substrat semi-conducteur (3), lesdites premières électrodes d'émetteur et de collecteur ayant de côtés respectifs en regard l'une de l'autre, et lesdites deuxièmes électrodes d'émetteur et de collecteur ayant des côtés respectifs en regard l'un de l'autre;
formation d'un deuxième film isolant (11, 12) simultanément sur lesdits côtés en regard l'un de l'autre des électrodes d'émetteur et de collecteur (9, 117, 10, 118) par formation successivement sur lesdits côtés, en regard l'un de l'autre, d'un film d'oxyde (11) par oxydation thermique et d'un film de SiO₂ par un procédé de dépôt chimique en phase vapeur (procédé CVD), en définissant ainsi des première et deuxième régions (104, 101) de formation de contact de base s'étendant de l'un à l'autre desdits côtés en regard l'un de l'autre desdites premières et deuxièmes électrodes d'émetteur et de collecteur (117, 118, 9, 10) au niveau de ladite surface principale au-dessus des parties respectives desdites première et deuxième couches de base (114, 5);
formation d'un deuxième film (119) de silicium polycristallin sur ledit substrat semi-conducteur (3) sur les première et deuxième régions entières (104, 101) de formation de contact de base;
introduction d'une impureté correspondant au second type de conductivité dans la partie dudit deuxième film (119) de silicium polycristallin qui s'étend au-dessus de ladite première région (101) de formation de contact de base;
introduction d'une impureté correspondant au premier type de conductivité dans la partie dudit deuxième film (119) de silicium polycristallin qui s'étend au-dessus de ladite première région (104) de formation de contact de base;
gravure dudit deuxième film (119) de silicium polycristallin en formant ainsi simultanément sur ladite surface principale une électrode de base (13) du transistor NPN et une électrode de base séparée (120) du transistor PNP, chaque électrode de base étant formée sur une région respective entière de formation de contact de base;
diffusion de l'impureté à partir desdites électrodes d'émetteur (9, 117), desdites électrodes de collecteur (10, 118), et desdites électrodes de base (13, 120), en formant ainsi des couches d'émetteur (15, 121), des couches (17, 123) de contact de collecteur, et des couches (16, 122) de contact de base du transistor NPN et du transistor PNP,
de sorte que la zone limite de la couche d'émetteur est exposée, au niveau de ladite surface principale et à un endroit situé directement en dessous de la partie dudit deuxième film isolant (11, 12) qui est formée sur ledit côté de ladite électrode d'émetteur (9, 117) du transistor NPN et du transistor PNP,respectivement et la zone limitc de la couche de contact de collecteur est exposée, au niveau de ladite surface principale et à un endroit situé directement en dessous de la partie dudit deuxième film isolant (11, 12) qui est formée sur ledit côté de ladite électrode de collecteur (10, 118) du transistor NPN et du transistor PNP, respectivement.

9. Procédé selon la revendication 8, dans lequel ladite couche d'émetteur (15, 121) et ladite couche (16, 122) de contact de base sont formées de manière à ne pas être directement en contact l'une avec l'autre dans le transistor NPN et dans le transistor PNP.

10. Procédé selon la revendication 8, dans lequel ladite couche (17, 123) et ladite couche (16, 122) de contact de base sont formée de manière à ne pas être directement en contact l'une avec l'autre dans le transistor NPN et dans le transistor PNP.

11. Procédé de fabrication d'un dispositif à semi-conducteurs comprenant un transistor bipolaire NPN et un transistor bipolaire PNP, comprenant les étapes successive de:
formation d'une région de caisson (113) dans une première région prédéterminée d'un substrat semi-conducteur (3) d'un premier type de conductivité comportant une surface principale, ladite région de caisson (113) étant d'un second type de conductivité opposé audit premier type de conductivité;
formation d'une première couche de base (114) du premier type de conductivité dans ladite région de caisson (113);
formation d'une deuxième couche de base (5) du second type de conductivité dans une deuxième région prédéterminée dudit substrat semi-conducteur (3);
formation d'un premier film (115) de silicium polycristallin sur ledit substrat semi-conducteur (3), s'étendant au-dessus desdites première et deuxième régions prédéterminées, ledit premier film (115) de silicium polycristallin comprenant une impureté correspondant au premier type de conductivité;
formation d'un premier film isolant (7) sur ledit premier film (115) de silicium polycristallin;
gravure dudit premier film isolant (7) et dudit premier film (115) de silicium polycristallin, en formant ainsi simultanément, sur ladite surface principale, une première électrode de base (120) sur une première région (104) de formation de contact de base de ladite première couche de base (114), ladite première électrode de base (120) comportant des surfaces latérales, et une première électrode d'émetteur (9) et une première électrode de collecteur (10), espacées l'une de l'autre, sur une région respective (100) de formation de contact d'émetteur de ladite deuxième couche de base (5) et sur une région respective (102) de formation de contact de collecteur dudit substrat semi-conducteur (3), lesdites premières électrodes d'émetteur et de collecteur comportant des côtés respectifs en regard l'un de l'autre;
formation d'un deuxième film isolant (11, 12) simultanément sur lesdites surfaces latérales de ladite première électrode de base (120) et sur lesdits côtés en regard l'un de l'autre desdites premières électrodes d'émetteur et de collecteur (9, 10) par formation successivement sur lesdites surfaces latérales et lesdits côtés, en regard l'un de l'autre, d'un film d'oxyde (11) par oxydation thermique et d'un film de SiO₂ par un procédé de dépôt chimique en phase vapeur (procédé CVD), en définissant ainsi une deuxième région (101) de formation de contact de base s'étendant de l'un à l'autre des côtés en regard desdites premières électrodes d'émetteur et de collecteur (9, 10) au niveau de ladite surface principale, au-dessus d'une partie de ladite deuxième couche de base (5),
formation d'un deuxième film (119) de silicium polycristallin sur ledit substrat semi-conducteur (3) de la deuxième région entière (101) de formation de contact de base et au-dessus de ladite première région prédéterminée;
introduction d'une impureté correspondant au deuxième type de conductivité dans ledit deuxième film (119) de silicium polycristallin;
gravure dudit deuxième film (119) de silicium polycristallin de manière à former simultanément, sur ladite surface principale, une deuxième électrode de base (13) sur la deuxième région entière (101) de formation de contact de base, et des deuxièmes électrodes séparées (117, 118) d'émetteur et de collecteur sur une région respective (103) de formation de contact d'émetteur de ladite première couche de basc (114) et une région respective (105) de formation de contact de collecteur de ladite région de caisson (113);
diffusion de l'impureté à partir desdites électrodes d'émetteur (9, 117), desdites électrodes de collecteur (10, 118), et desdites électrodes de base (13, 120), en formant ainsi des couches d'émetteur (15, 121), des couches (17, 123) de contact de collecteur, et des couches (16, 122) de contact de base du transistor NPN et du transistor PNP,
de sorte que la zone limite de la couche d'émetteur est exposée, au niveau de ladite surface principale et à un endroit situé directement en dessous de la partie dudit deuxième film isolant (11, 12) qui est formée sur ledit côté de ladite électrode d'émetteur (9, 117) du transistor NPN et du transistor PNP, et la zone limite de la couche dc contact de collecteur est exposée, au niveau de ladite surface principale et à un endroit situé directement en dessous de la partie dudit deuxième film isolant (11, 12) qui est formée sur ledit côté de ladite électrode de collecteur (10, 118) dans le transistor NPN et dans le transistor PNP, respectivement.

12. Procédé selon la revendication 11, dans lequel ladite couche d'émetteur (15, 121) et ladite couche (16, 122) de contact de base sont formées de manière à ne pas être directement en contact l'une avec l'autre dans le transistor NPN et dans le transistor PNP, respectivement.

13. Procédé selon la revendication 11, dans lequel ladite couche (17, 123) de contact de collecteur et ladite couche de contact de base (16, 122) sont formées de manière à ne pas être directement en contact l'une avec l'autre dans le transistor NPN et dans le transistor PNP, respectivement.
